(19) Europäisches Patentamt / European Patent Office / Office européen des brevets

(11) **EP 4 455 802 A1**

(12) **EUROPEAN PATENT APPLICATION**

(43) Date of publication:
**30.10.2024 Bulletin 2024/44**

(21) Application number: **23169445.6**

(22) Date of filing: **24.04.2023**

(51) International Patent Classification (IPC):
**G05B 13/04** (2006.01)     **G05B 19/19** (2006.01)
**G05B 19/416** (2006.01)

(52) Cooperative Patent Classification (CPC):
**G05B 13/042; G05B 19/19;** G05B 19/416

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Siemens Healthineers AG**
**91301 Forchheim (DE)**

(72) Inventors:
• **LIESCHKE, Frank**
**70771 Leinfelden-Echterdingen (DE)**

• **HECHT, Martin**
**95508 Kulmain (DE)**
• **RASTOGI, Shivam**
**95652 Waldsassen (DE)**
• **SCHÖCKLMANN, Thomas**
**95478 Kemnath (DE)**
• **SCHLIERMANN, Claus-Günter**
**95478 Kemnath (DE)**
• **WEISS, Lutz**
**95448 Bayreuth (DE)**

(74) Representative: **Siemens Healthineers Patent Attorneys**
**Postfach 22 16 34**
**80506 München (DE)**

(54) **TECHNIQUE FOR ASSEMBLING A STATE SPACE MODEL SYSTEM**

(57) A computer implemented method (100) of assembling a state space model system for controlling a movement of a component of a mechatronic system comprises specifying (S102) a set of input parameters and a set of output parameters for an initial set of state space models, which is determined (S104) by mapping multiple sets of values of the specified (S102) set of input parameters to multiple associated sets of values of the specified (S102) set of output parameters. The determined (S104) initial set of state space models is optimized (S106) by identifying (S106-1) approximately linear regions, which comprise regions in a parameter space of the initial set of state space models, and selecting (S106-2) one state space model per approximately linear region. The parameter space comprises the input parameters and the output parameters. The selected state space models are assembled (S108) for obtaining the state space model system.

FIG 1

EP 4 455 802 A1

**Description**

The present invention relates to a technique for assembling a state space model system for controlling a movement of a component of a mechatronic system. In particular, a method, a computing device, a system comprising the computing device and a computer program product are provided.

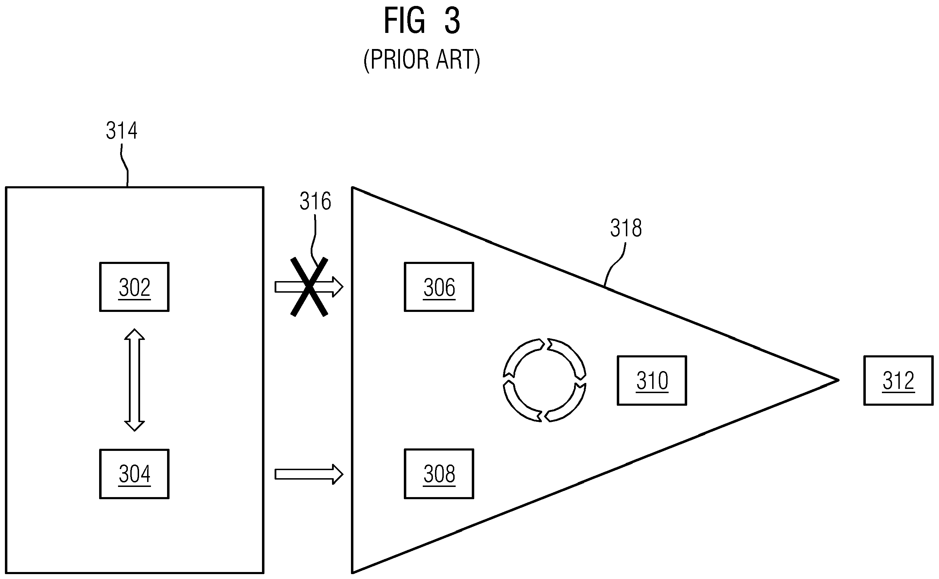

Creating high-fidelity models 302 for a mechatronic system 312 conventionally requires commercial software during the model development phase (e.g., as schematically depicted in Fig. 3). Commercial software is typically required too for performing simulations 306 by means of those models 302. It is very beneficial for the performance of a system to run simulations in parallel on control units 304; 308 while operating such systems. This, conventionally, requires run-time licenses of the software provider. The need for run-time licenses creates dependencies that might become critical at some point in the future.

There are two conventional main options. Companies for example provide, by means of an additional software package, high-level language code 306 of an existing model developed in a (in particular commercial) software for multi-domain simulation 302. This can then be compiled for a variety of hardware platforms 310. Alternatively, one can develop the software 306 to describe the system directly and compile that for the target platform 310.

Fig. 3 exemplarily shows a mechanical model 302, which is also denoted as high-fidelity simulation tool and/or professional software package for the simulation of Multi-Body Dynamics (MBD), or (in particular commercial) multi-body simulation software. At the same high level 314, a control system model 304, which is also denoted as domain specific tool (and/or, e.g., may make use of, in particular commercial, software for multi-domain simulation) is implemented.

At the lower level 318, the derived 306 mechanical model (also denoted as new mechanical model, e.g., conventionally making use of, in particular commercial, software for multi-domain simulation), the corresponding control system model 308 (e.g., using the conventional commercial software for multi-domain simulation), and the application software 310 for the mechatronic system 312 (also denoted as mechatronic framework) are schematically depicted.

A key problem of the conventional set-up comprises a need for laborious, complex, and/or costly re-engineering of the high-fidelity model 302, as schematically indicated at reference sign 316, e.g., when the mechatronic system 312 is upgraded and/or extended. Over time, and in particular when performing an upgrade of the hardware of the mechatronic system or of a computing system connected thereto, it is conventionally also necessary to perform extensive, and/or costly changes in the software, including third-party licensed software which cannot be changed by the operator of the mechatronic system.

It is therefore an object of the present invention to provide a solution for simulating and controlling (in particular in real-time) the movement of a component of a mechatronic system that is (in particular software, and/or hardware) tool-independent, and/or platform-independent. Alternatively or in addition, an object of the present invention is to provide a technique that dispenses with the need for re-engineering, and/or keeps a developed workflow, e.g., upon repair, extension, and/or upgrade of the mechatronic system. Further, alternatively or in addition, an object of the present invention is to provide a technique that is scalable with complexity, accuracy, and/or speed of the simulation.

This object is solved by a (in particular computer-implemented) method of assembling a state space model system for controlling a movement of a component of a mechatronic system, by a computing device, by a system comprising the computing device, by a computer program (and/or computer program product), and by a computer-readable storage medium according to the appended independent claims. Advantageous aspects, features and embodiments are described in the dependent claims and in the following description together with advantages.

Independent of the grammatical term usage, individuals with male, female or other gender identities are included within the term.

In the following, the solution according to the invention is described with respect to the claimed method as well as with respect to the claimed computing device. Definitions, features, advantages or alternative embodiments herein can be assigned to the other claimed objects (e.g., the system, the computer program or a computer program product), and vice versa. In other words, claims for the computing device, and/or the system comprising the computing device can be improved with features described or claimed in the context of the methods and vice versa. In this case, the functional features of the method are embodied by structural units (and/or modules) of the system and vice versa, respectively.

As to a method aspect, a (in particular computer-implemented) method of assembling a state space model system, in particular a linearized state space model system, for controlling a movement of a component of a mechatronic system is provided. The method comprises a step of specifying a set of input parameters for controlling a movement of a component of a mechatronic system and a set of output parameters for an initial set of state space models. The method further comprises a step of determining the initial set of state space models by mapping multiple sets of values of the specified set of input parameters to multiple associated sets of values of the specified set of output parameters. The method further comprises a step of optimizing the determined initial set of state space models by identifying approximately linear regions and selecting one state space model per approximately linear region. The approximately linear regions comprise regions in a parameter space of the initial set of state space models. The parameter space comprises the set of input parameters and the set of output parameters. The method still further comprises a step of assembling the selected state space models per approximately linear region for obtaining a (e.g., linearized) state space model system for controlling the movement of the component of the mechatronic system.

The term "a component" herein, preferably, refers to at least one component. Thus, the mechatronic system may comprise more than one component and e.g., several different components, like, e.g., a C-arm and a patient table. The component may also be denoted as hardware. The component may, e.g., comprise a patient table and/or a C-arm for use in an image acquisition device (scanner). E.g., the mechatronic system may comprise a medical scanner system comprising the patient table and/or the C-arm. Alternatively or in addition, the mechatronic system may comprise the patient table and/or the C-arm. E.g., the component of the patient table and/or the C-arm (which may also be denoted as a subcomponent of medical scanner system) may comprise translatory means along a direction (e.g., an upwards and downwards, and/or a longitudinal, movement of the patient table and/or the C-arm) and/or rotatory means along an axis (e.g., for rotating at least parts of the patient table and/or the C-arm).

The mechatronic system may comprise electronics, and/or a motor system, for moving and/or controlling the component by control instructions.

By the obtained (and/or assembled) state space model system, a simple tool-independent, and/or platform-independent, simulation tool may be provided that may be scalable with complexity (e.g., of the component), with a (e.g., desired) accuracy, and/or with a (e.g., desired) simulation speed.

The simulation tool may be part of a surveillance system for monitoring the component of the mechatronic system, and/or may be used for controlling the movement (also denoted as motion) of the component.

The obtained (and/or assembled) state space model system may provide numerically stable, observable, and/or controllable output parameters for controlling the movement of the component.

Alternatively or in addition, by controlling the movement of the component by means of the obtained (and/or assembled) state space model system, less sensors for monitoring the mechatronic system (and/or in particular the component) may be required, and/or a fail-safe mode may be enabled, and/or provided.

The fail-safe mode may, e.g., be activated, if non-normal, and/or faulty, movements or states of the component are detected by means of the state space model system.

The obtained (and/or assembled) state space model system may, e.g., be utilized for detecting a load on the component, for detecting a friction along a load path, for detecting (e.g., unwanted) resonance effects, for optimizing a drive system and/or a gear ratio (also denoted as gearing, and/or step-up gear), and/or for anticipating a need for maintenance (e.g., due to wear, in particular based on friction).

By the linear behavior of each state space model, couplings among several components of the mechatronic system may be easily integrated. Alternatively or in addition, by the linear behavior of each state space model, the state space model system may be easily adjusted (and/or updated) upon a maintenance, development, upgrade and/or any further measure performed on the component of the mechatronic system. Alternatively or in addition, a need for re-engineering may be dispensed with.

The (e.g., initial set of) state space model(s) may be based on a (e.g., non-linear) mechanical model, and/or a (e.g., non-linear) high-fidelity simulation tool. The (e.g., non-linear) mechanical model, and/or the (e.g., non-linear) high-fidelity simulation tool, may alternatively be denoted as digital twin. The digital twin may serve as functional digital representation for the mechatronic system with its at least one component.

Alternatively or in addition, each of the state space models may correspond to an operational point of the (e.g., non-linear) mechanical model, and/or of the component of the mechatronic system. The set of operational points may also be denoted as scheduling space. Alternatively or in addition, the scheduling space may comprise a set of linearization points (e.g., corresponding to the operational points).

A state space (also denoted as phase space) may comprise a (e.g., discrete) space representing the set of all possible configurations and/or states (e.g., positions) of a (e.g., mechatronic) system.

A state-space representation may comprise a (e.g., mathematical) model of a physical (and/or technical, in particular mechatronic) system specified as a set of input parameters (briefly also denoted as input), output parameters (briefly also denoted as output) and internal parameters (also denoted as variables) related by first-order (e.g., not involving second derivatives) differential equations, and/or difference equations. Such variables (also denoted as state parameters, and/or *state variables*) may evolve over time in a way that depends on the values they have at any given instant and on the externally imposed values of the input. Output values may depend on the values of the state variables.

Anyone, or each, input parameter may comprise a physical (and/or technical) parameter for the controlling of the movement of the component. Alternatively or in addition, anyone, or each, output parameter may comprise a physical (and/or technical) parameter, in particular indicative of a (in particular external) force exerted, a load situation, and/or a friction. Alternatively or in addition, anyone, or each, of the output parameter may comprise a distance (e.g., traveled by the component), a frequency (and/or a frequency response, and/or vibration, of the component), and/or a time scale (e.g., a delay). Further alternatively or in addition, the internal parameters may comprise physical (and/or technical) parameters, e.g., one or more spring constants (e.g., in relation to a drive mechanism), and/or inertial tensors (e.g., in relation to a patient, and/or a load).

The determined initial set of state space models may comprise a set of linear functions, linear matrix operations, and/or a system of linear differential equations. Alternatively or in addition, the determined initial set of state space models may comprise a linear time-invariant (LTI) model for each state space model.

An approximately linear region may comprise a subset of the set of state space models comprising approximately equal (e.g., for different input parameters within the linear region) linear functions, (e.g., linear) matrices, and/or coefficients of the system of linear differential equations.

The optimizing of the determined initial set of state space models may comprise reducing the number of state space models, in particular by selecting one representative (e.g., for the linear function, the matrix, and/or the coefficients) per approximately linear region.

Assembling the selected state space models may refer to generating an obtained state space model system. Assembling the selected state space models may comprise concatenating the (e.g., associated linear functions, and/or matrices of the) selected state space models. Alternatively or in addition, the state space model system may be or comprise an (in particular affine) linear parameter varying (LPV) system. The affine LPV may comprise (e.g., constant) offsets from linear functional relationships of the input parameters and output parameters of the LPV system.

Alternatively or in addition the method may further comprise the step of calculating control instructions for movement of the component, based on the assembled or obtained state space model (in particular, the affine LPV model).

At least one, or each, state space model within the determined initial set of state space models may comprise a linear time-invariant (LTI) model.

Anyone, or each, of the state space models may comprise a representation in terms of a linear function, a (e.g., linear) matrix system, and/or a set of linear differential equations thereof.

The assembled state space model system may comprise or may be a, in particular affine, LPV system. The assembled state space model system is different from the initial set of state space models. The assembled state space model system may be understood as newly generated state space model system and in particular as a LPV system and more particular as an affine LPV system. An affine LPV system is an LPV system whose matrices are affine functions of the parameters. In this application the terms "state space model system" refers to the system which is generated, based on the state space models.

The LPV system may comprise a set of operational points. Each operational point may correspond to one of the selected state space models. Alternatively or in addition, the LPV system may comprise a set of coupled linear differential equations for an input vector (in particular representing the input parameters), a state vector (e.g., representing internal parameters of the component), an output vector (in particular representing the output parameters) and a set of (in particular four) matrices.

Two of the matrices (e.g., denoted as input matrix and feedthrough, and/or feedback, matrix) may act on the input vector. Two further matrices (e.g., denoted as state matrix and output matrix) may act on the state vector.

Alternatively or in addition, the LPV system may comprise a set of (in particular four) matrices, and optionally constant offsets, per operational point of the component of the mechatronic system. Further alternatively or in addition, an affine LPV system may refer to, and/or may comprise, one or more constant offsets (e.g., independently determined per operational point).

The method may further comprise a step of reducing the assembled state space model system according to a predetermined threshold of a resolution (and/or a predetermined threshold on a granularity of the state space model system).

After the assembling of the state space model system, the number of operational points may be reduced depending on the needs of a resolution (and/or a granularity).

By reducing the number of operational points, and thereby the resolution (and/or the granularity), the controlling of the movement may be sped up. This may be particularly relevant for real-time applications.

The method may further comprise a step of receiving a further set of values of the set of input parameters. The further set of values of the set of input parameters may be received from (e.g., a controller of) the component of the mechatronic system, in particular while the component of the mechatronic system is in use (e.g., subjected to a, in particular external, load and/or force).

Alternatively or in addition, the method may further comprise a step of applying the assembled, and/or the reduced, state space model system to the received further set of values of the set of input parameters and obtaining an associated further set of values of the set of output parameters. Applying the assembled state space model may thus be used for generating control instructions for the component's movement for new states (e.g. for new parameters, like different patient's weight etc.).

Alternatively or in addition, the method may further comprise a step of outputting the obtained associated further set of values of the set of output parameters.

Alternatively or in addition, the method may further comprise a step of outputting an indication of at least one value of the further set of values of the set of output parameters crossing a predetermined threshold (e.g., a, in particular external, force, and/or load, on the component of the mechatronic system exceeding a predetermined threshold).

The output of the obtained associated further set of values of the set of output parameters, and/or of the indication of at least one value of the further set of values of the set of output parameters crossing a predetermined threshold, may comprise an output on a display, UI, and/or GUI.

Alternatively or in addition, the output of the obtained associated further set of values of the set of output parameters, and/or of the indication of at least one value of the further set of values of the set of output parameters crossing a predetermined threshold, may comprise an (e.g., system-internal) output, e.g., to a controller of the component of the mechatronic system.

Alternatively or in addition, the method may further comprise a step of controlling, based on (and/or in dependence of) the obtained and/or output associated further set of values of the set of output parameters (briefly also: further values of output parameters) and/or based on (and/or in dependence of) the output indication of the crossing of the predetermined threshold, the movement of the component of the mechatronic system.

Controlling the movement of the component of the mechatronic system may comprise outputting a control command (also: control instruction). Alternatively or in addition, the step of controlling the movement of the component of the mechatronic system may be performed by the controller of the component of the mechatronic system.

The controlling based on (and/or in dependence of) the further values of the output parameters, and/or based on (and/or in dependence of) the indication of the crossing of the predetermined threshold may comprise adjusting, e.g., a motor current and/or a torque. E.g., a motor current and/or torque may be increased to compensate for an external force and/or load, which effectively increases the inertia of the component of the mechatronic system.

Alternatively or in addition, the method may further comprise a step of, responsive to the obtained and/or output associated further set of values of the set of output parameters and/or responsive to the output indication of the crossing of the predetermined threshold, initiating a maintenance procedure of the component of the mechatronic system.

The predetermined threshold may, e.g., be indicative of a wear of the component. Alternatively or in addition, a distance travelled below a predetermined threshold may be indicative of an amount of friction surpassing a tolerance for normal operation (e.g., movement) of the component.

Further alternatively or in addition, the predetermined threshold may comprise a deviation from a measured value, e.g., a deviation of a distance output by the state space model system from a measured (e.g., by a sensor) displacement of a patient table.

The predetermined threshold may comprise a distance travelled by the component. Alternatively or in addition, the predetermined threshold may comprise a time until a predetermined position is reached by the component. Further alternatively or in addition, the predetermined threshold may comprise a frequency response by the component.

The state space model system may comprise a comparator for comparing one or more of the obtained further set of values of the set of output parameters with one or more predetermined thresholds.

Anyone of the predetermined threshold values may depend on the set of values of the set of input parameters.

A maintenance procedure may, e.g., be initiated if the output indicates that a (e.g., accumulated) friction, and/or (e.g., accumulated) load, exceeds a predetermined threshold. Alternatively or in addition, a maintenance procedure may, e.g., be initiated if the output indicates that the component of the mechatronic system is controlled (and/or operated) far from an optimal operating point. The optimal operating point may, e.g., have been determined during a design phase of the component of the mechatronic system.

The component of the mechatronic system may be or comprise a patient table (e.g., for a mechatronic system comprising a medical scanner system). Alternatively or in addition, the component of the mechatronic system may be or comprise a C-arm (e.g., for a mechatronic system comprising a medical scanner system).

Alternatively or in addition, the component of the mechatronic system may comprise a drive system (e.g., for a mechatronic system comprising a patient table and/or a C-arm). Further alternatively or in addition, the component of the mechatronic system may comprise a gearing mechanism (e.g., for a mechatronic system comprising a patient table and/or a C-arm). Still further alternatively or in addition, the component of the mechatronic system may comprise a pulley.

The drive system, the gearing mechanism, and/or the pulley may serve to move (e.g., translate, and/or rotate) the patient table, and/or the C-arm, e.g., for medical imaging.

The set of input parameters may comprise a motor control command, in particular a motor current, and/or a motor torque.

The motor control command may serve as control instruction and/or may be configured for moving the component of the mechatronic system by means of an (e.g., electronic) controller.

The set of output parameters may comprise (in particular an estimation of) a (in particular external) force and/or load (also denoted as burden, and/or strain).

Alternatively or in addition, the set of output parameters may comprise (in particular an estimation of) a mass. Alternatively or in addition, the set of output parameters may comprise (in particular an estimation of) a (e.g., external) force. Alternatively or in addition, the set of output parameters may comprise (in particular an estimation of) a friction (and/or a frictional force). Alternatively or in addition, the set of output parameters may comprise (in particular an estimation of) a distance travelled. Further alternatively or in addition, the set of output parameters may comprise (in particular an estimation of) a rotation angle.

The set of output parameters may comprise an estimation of a patient mass. Alternatively or in addition, the output parameter may comprise a friction affecting the component.

The output parameter comprising the friction may comprise a frequentness (prevalence, abundance, and/or number of times) of moving the component (e.g., by translations, and/or rotations) .

The specifying of the set of input parameters and the set of output parameters may comprise receiving an input from a user interface (UI).

Alternatively or in addition, the receiving of the further set of values of the set of input parameters may comprise receiving an input from the UI.

The UI may comprise a graphical user interface (GUI). Alternatively or in addition, the input from the UI may comprise a manual input by a user.

The initial set of state space models may be based on a, in particular non-linear, mechanical model.

The movement of the component may comprise a translation of the component. Alternatively or in addition, the movement of the component may comprise a rotation of the component.

The translation may, e.g., comprise moving a patient table into a medical imaging scanner (e.g., a tube for magnetic resonance imaging, MRI, and/or for computed tomography, CT).

The rotation may, e.g., comprise tilting the patient table, and/or tilting a C-arm, in particular by rotating the patient table and/or the C-arm around a predetermined axis.

As to a device aspect, a computing device for assembling a state space model system for controlling a movement of a component of a mechatronic system is provided. The computing device comprises a specifying module configured for specifying a set of input parameters for controlling a movement of a component of a mechatronic system and a set of output parameters for an initial set of state space models. The computing device further comprises a determining module configured for determining the initial set of state space models by mapping multiple sets of values of the specified set of input parameters to multiple associated sets of values of the specified set of output parameters. The computing device further comprises an optimizing module configured for optimizing the determined initial set of state space models by identifying approximately linear regions and selecting one state space model per approximately linear region. The approximately linear regions comprise regions in a parameter space of the initial set of state space models. The parameter space comprises the set of input parameters and the set of output parameters. The computing device still further comprises an assembling module configured for assembling the selected state space models per approximately linear region for obtaining a state space model system for controlling the movement of the component of the mechatronic system.

The computing device may be further configured for performing anyone of the steps, or comprising anyone of the features, disclosed in the context of the method aspect.

As to a system aspect, a system for assembling a state space model system for controlling a movement of a component of a mechatronic system is provided. The system comprises a computing device according to the device aspect. The system further comprises at least one component of a mechatronic system, the movement of which is controlled by the computing device.

As to a further aspect, a computer program product is provided comprising program elements which induce a computing device, when the program elements are loaded into a memory of the computing device, to carry out the steps of the method of assembling a state space model system for controlling a movement of a component of a mechatronic system according to the method aspect.

As to a still further aspect, a computer-readable medium is provided, on which program elements are stored that can be read and executed by a computing device, when the program elements are executed by the computing device, in order to perform steps of the method of assembling a state space model system for controlling a movement of a component of a mechatronic system according to the method aspect.

The properties, features and advantages of this invention described above, as well as the manner they are achieved, become clearer and more understandable in the light of the following description and embodiments, which will be described in more detail in the context of the drawings. This following description does not limit the invention on the contained embodiments. Same components or parts can be labeled with the same reference signs in different figures. In general, the figures are not for scale.

It shall be understood that a preferred embodiment of the present invention can also be any combination of the dependent claims or above embodiments with the respective independent claim.

These and other aspects of the invention will be apparent from and elucidated with reference to the embodiments described hereinafter.

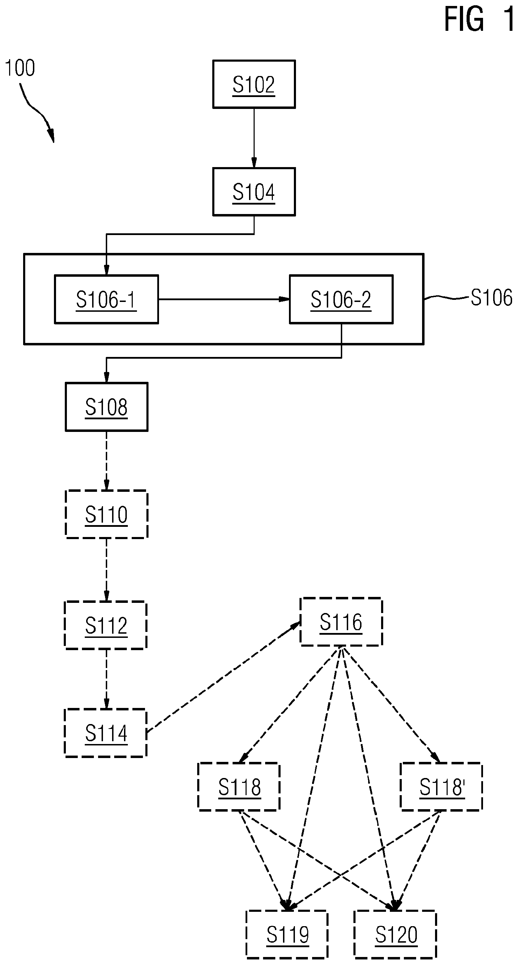

Fig. 1           is a flow chart of a method of assembling a state space model system for controlling a movement of a component of a mechatronic system according to a preferred embodiment of the present invention;

| | |
|---|---|
| Fig. 2 | is an overview of the structure and architecture of a computing device for assembling a state space model system for controlling a movement of a component of a mechatronic system according to a preferred embodiment of the present invention, which computing device may be configured for performing the method of Fig. 1; |
| Fig. 3 | schematically illustrates the conventional relations between a (in particular non-linear) mechanical model and application to controlling a component of a mechatronic system; |
| Fig. 4 | schematically illustrates the relations between a (in particular non-linear) mechanical model and application to controlling a component of a mechatronic system according to the inventive technique, in particular by making use of the method of Fig. 1; |
| Fig. 5 | schematically illustrates the steps of specifying the set of input and output parameters and determining the initial set of state space models by means of the method of Fig. 1 for a first embodiment of a component of a mechatronic system, which comprises a C-arm with three axes of rotation; |
| Fig. 6 | schematically illustrates the step of selecting a state space model and/or operational point according to the method of Fig. 1 for the first embodiment of Fig. 5; |
| Fig. 7 | schematically illustrates a tool-independent simulation of an affine LPV system for a C-arm or patient table as component of the mechatronic system and a notebook, smartphone and tablet PC as examples of the computing device of Fig. 2 for performing the method of Fig. 1; |
| Figs. 8A, | 8B, 8C schematically illustrate workflow examples for embodiments of estimating a patient mass parameter, a friction parameter, and/or detecting a patient motion by means of the method of Fig. 1; |
| Fig. 9 | schematically illustrates rotations by small and large angles of a patient table in connection with a patient's inertia, which may be used to detect a motion of the patient by means of the method of Fig. 1; |
| Fig. 10 | schematically illustrates an example of a state space model system with input, states and output, e.g., for a linear spring; |
| Figs. 11A, | 11B and 11C schematically illustrate a further state space model system, e.g., for a non-linear spring, at three different operation points comprised in an LPV system; |
| Figs. 12A and 12B | show exemplary entries of state variables and LPV system matrices, respectively, at an operating point; |
| Fig. 13 | shows another embodiment of a patient table as component of a mechatronic system, to which the method of Fig. 1 may be applied; |
| Fig. 14 | schematically illustrates the steps of specifying the set of input and output parameters and determining the initial set of state space models by means of the method of Fig. 1 for the embodiment comprising the patient table of Fig. 13; |
| Fig. 15 | schematically illustrates a tool-independent simulation of an affine LPV system for the embodiment comprising the patient table of Fig. 13; |
| Fig. 16 | shows examples a non-linear response of a movement around an axis depending on a torque applied; |
| Fig. 17 | shows the patient table of the embodiment of Fig. 13 in a tilted positions; |
| Fig. 18 | schematically illustrates the movement in terms of a speed and displacement along three different axes of the patient table of the embodiment of Figs. 13 and 17 over time; |

Fig. 19          schematically provides a further illustration of the patient table of the embodiment of Figs. 13 and 17, or a similar, in particular longer, patient table; and

Fig. 20A and 20B          schematically illustrate the use of different LPV system IDs for different steps in time and displacement of the patient table of Fig. 19.

Any reference signs in the claims should not be construed as limiting the scope.

Fig. 1 schematically illustrates a flowchart of a (in particular computer-implemented) method of assembling a state space model system for controlling a movement of a component of a mechatronic system. The method is generally referred to by the reference sign 100.

The method 100 comprises a step S102 of specifying a set of input parameters for controlling a movement of a component of a mechatronic system and a set of output parameters for an initial set of state space models.

The method 100 further comprises a step S104 of determining the initial set of state space models by mapping multiple sets of values of the specified S102 set of input parameters to multiple associated sets of values of the specified S102 set of output parameters.

The method 100 further comprises a step S106 of optimizing the determined initial set of state space models by identifying S106-1 approximately linear regions and selecting S106-2 one state space model per approximately linear region. The approximately linear regions comprise regions in a parameter space of the initial set of state space models. The parameter space comprises the set of input parameters and the set of output parameters.

The method 100 still further comprises a step S108 of assembling the selected S106-2 state space models per approximately linear region for obtaining a state space model system for controlling the movement of the component of the mechatronic system.

Optionally, the method 100 comprises a step S110 of reducing the assembled S108 state space model system according to a predetermined threshold of a resolution.

Further optionally, the method 100 comprises a step S112 of receiving a further set of values of the set of input parameters, in particular from a controller of the component of the mechatronic system.

The method 100 may further comprise a step S114 of applying the assembled S108, and/or the reduced S110, state space model system to the received S112 further set of values of the set of input parameters and obtaining S116 an associated further set of values of the set of output parameters.

The method 100 may still further comprise a step S118 of outputting the obtained S116 associated further set of values of the set of output parameters.

Alternatively or in addition, the method 100 may comprise a step S118' of outputting an indication of at least one value of the further set of values of the set of output parameters crossing a predetermined threshold.

Anyone of the steps S118 or S118' may comprise an output on a display, UI, and/or GUI. Alternatively or in addition, anyone of the steps S118 or S118' may comprise an output (e.g., as digital data) to a controller of the component of the mechatronic system.

Alternatively or in addition, the method 100 may comprise a step S119 of controlling (e.g., by outputting a control command), based on (and/or in dependence of) the obtained S116 and/or the output S118 associated further set of values of the set of output parameters and/or based on (and/or in dependence of) the output S118' indication of the crossing of the predetermined threshold, the movement of the component of the mechatronic system.

The step S119 of controlling may, e.g., be performed by the controller of the component of the mechatronic system.

Alternatively or in addition, the method 100 may comprise a step S120 of initiating, responsive to the obtained S116 and/or output S118 associated further set of values of the set of output parameters, and/or responsive to the output S118' indication of the crossing of the predetermined threshold, a maintenance procedure of the component of the mechatronic system.

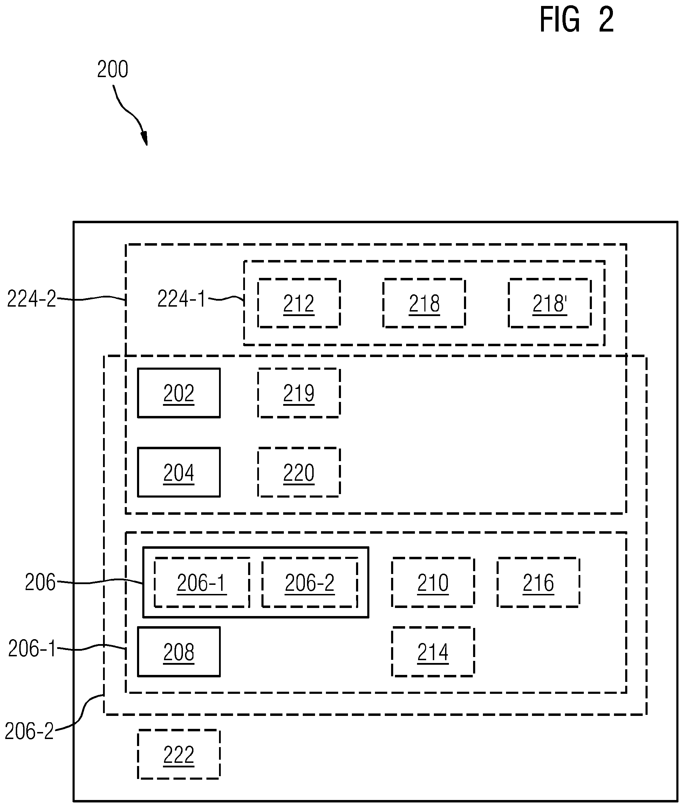

Fig. 2 schematically illustrates a structure and architecture of a computing device for assembling a state space model system for controlling a movement of a component of a mechatronic system. The computing device is generally referred to by the reference sign 200.

The computing device 200 comprises a specifying module 202 configured for specifying a set of input parameters for controlling a movement of a component of a mechatronic system and a set of output parameters for an initial set of state space models.

The computing device 200 further comprises a determining module 204 configured for determining the initial set of state space models by mapping multiple sets of values of the specified set of input parameters to multiple associated sets of values of the specified set of output parameters.

The computing device 200 further comprises an optimizing module 206 configured for optimizing the determined initial set of state space models by identifying approximately linear regions and selecting one state space model per approximately linear region. The approximately linear regions comprise regions in a parameter space of the initial set of state space models. The parameter space comprises the set of input parameters and the set of output parameters.

Optionally, the optimizing module 206 may comprise an identifying submodule 206-1 configured for the identifying of the approximately linear regions and a selecting submodule 206-2 configured for the selecting of one state space model per approximately linear region.

The computing device 200 still further comprises an assembling module 208 configured for assembling the selected state space models per approximately linear region for obtaining a state space model system for controlling the movement of the component of the mechatronic system.

Optionally, the computing device 200 may comprise a reducing module 210 configured for reducing the assembled state space model system according to a predetermined threshold of a resolution.

Further optionally, the computing device 200 may comprise a receiving interface 212 configured for receiving a further set of values of the set of input parameters, in particular from a controller of the component of the mechatronic system.

Further optionally, the computing device 200 may comprise an applying module 214 configured for applying the assembled, and/or the reduced, state space model system to the received further set of values of the set of input parameters. Alternatively or in addition, the computing device 200 may comprise an obtaining module 216 configured for obtaining an associated further set of values of the set of output parameters.

Still further optionally, the computing device 200 may comprise a first outputting interface 218 configured for outputting the obtained associated further set of values of the set of output parameters.

Alternatively or in addition, the computing device 200 may comprise a second outputting interface 218' configured for outputting an indication of at least one value of the further set of values of the set of output parameters crossing a predetermined threshold.

Alternatively or in addition, the computing device 200 may comprise a controlling module 219 configured for controlling, based on the obtained and/or output associated further set of values of the set of output parameters and/or based on the output indication of the crossing of the predetermined threshold, the movement of the component of the mechatronic system.

The controlling module 219 may also be denoted as controller of the component of the mechatronic system.

Further alternatively or in addition, the computing device 200 may comprise a maintenance initiating module 220 configured for initiating, responsive to the obtained and/or output associated further set of values of the set of output parameters, and/or responsive to the output indication of the crossing of the predetermined threshold, a maintenance procedure of the component of the mechatronic system.

Still further alternatively or in addition, the computing device 200 may comprise a memory 222, e.g., for storing instructions for performing the steps of the method 100.

Anyone of the receiving interface 212, the first outputting interface 218, and/or the second outputting interface 218' may be comprised in an input-output interface 224-1 or 224-2.

The input-output interface 224-2 may, in addition to anyone of the optional receiving interface 212, the optional first outputting interface 218, and/or the optional second outputting interface 218', comprise input-output components of the specifying module 202, the determining module 204, the optional controlling module 219, and/or the optional maintenance initiating module 220.

Anyone of the optimization module 206, the assembling module 208, the optional reducing module 210, the optional applying module, and/or the optional obtaining module may be comprised in a processor, in particular a central processing unit (CPU), 226-1 or 226-2.

The processor (e.g., CPU) 226-2 may, in addition to the assembling module 208, the optional reducing module 210, the optional applying module, and/or the optional obtaining module, comprise processing components of the specifying module 202, the determining module 204, the optional controlling module 219, and/or the optional maintenance initiating module 220.

The computing device 200 may be configured to perform the method 100.

The inventive technique (e.g., comprising the method 100, the computing device 200, and/or a system comprising the computing device 200 and a mechatronic system to be controlled) may also be denoted as Tool- And Platform Independent Simulation (TAPIS), and/or as performance-oriented simulation of non-linear systems in state-space.

Conventionally, commercially available software products for high-fidelity simulation offer a feature that describes the mechatronic system at an operating point by means of a state-space representation. The state-space representation at the operating point (also denoted as linear state-space model) is essentially a linearization of the behavior of the mechatronic system at the operating point. From a mathematical point of view, a matrix-structure is used to represent the mechatronic system. For one and the same model, the structure of the mechatronic system remains identical though the matrix-elements vary from one operating point to the next one. Concatenation of such linear state-space models may be used to describe the mechatronic system - even non-linear ones - in the whole region of interest. The system theory calls such a concatenation of linear state-space models linear parameter-varying (LPV) system. An extended version of the LPV system is called affine form of the LPV system (briefly also: affine LPV system). The affine LPV system takes so called offsets into account.

The inventive technique drives the high-fidelity model along a series of linearization points (as, e.g., initial, set of state space models), which may also be called as operating points, and/or collectively as scheduling space. The total number of linearization points may depend on the dimension of the scheduling space and on the non-linearity of the high-fidelity model. The total number of linearization points is finite, but can be large.

Having derived a number of linear state-space models and corresponding offsets, the (e.g., affine) LPV system may be parameterized (e.g., comprising a mathematical structure).

The (e.g., affine) LPV system may be discretized. Alternatively or in addition, the (e.g., discretization of the, in particular affine) LPV system may be solved by a fixed-step solver. Alternatively or in addition, the (e.g., discretization of the, in particular affine) LPV system may be run independently of the (e.g., software) tool used to develop the high-fidelity model. Further alternatively or in addition, the (e.g., discretization of the, in particular affine) LPV system may be operated on any target platform of interest (e.g., on any hardware, and/or on any computing device).

Assuming the (in particular initial) set of state space models (and/or high-fidelity model) was built by means of commercial software, it typically requires licenses to run simulations of the (in particular initial) set of state space models (and/or high-fidelity model). Moreover, specific precompiled libraries might be required when running simulations. The requirement of licenses and precompiled libraries conventionally limits the number of platforms where the simulation can be carried out. Alternatively or in addition, the number of components of mechatronic systems, for which simulations can be run, is conventionally limited.

The inventive state space model system (e.g., the affine LPV system) comprises a (e.g., purely mathematical, in particular versus the conventional licensed software-based modeling) human readable representation of the (in particular initial) set of state space models (and/or high-fidelity model).

A variety of fixed-step solvers may be applicable to the LPV system. Alternatively or in addition, the LPV system may be planted on any software or hardware platform for simulation purposes (e.g., contrarily to conventional simulation tools that are limited in software and/or hardware platforms).

According to the inventive technique, a (in particular initial) set of state space models (and/or high-fidelity model) may be essentially disconnected from its development environment, and/or development tool, by means of a universal description format of the state space model system, which may in particular be known as affine LPV system. Due to the disconnection of the (in particular initial) set of state space models (and/or high-fidelity model) from the development environment, and/or development tool, no specific software platform (and/or limitations, e.g., involving software licenses) will be required when running the simulation.

The (in particular affine) LPV system may be (e.g., essentially) viewed as an image of the in particular initial) set of state space models (and/or the high-fidelity model). The universal format, e.g., called LPV system, can lead to software and/or hardware autonomy regarding the simulation of a (in particular initial) set of state space models (and/or high-fidelity model).

From a maintenance and/or development point of view, it may be much simpler to improve a model within the (in particular initial) set of state space models (and/or high-fidelity simulation tool) and to use the developed workflow to build the LPV system holding enhancements, e.g., as compared to conventional debugging or extending model complexity by means of a high-level language like C, C++, Java or Fortran.

Furthermore, the LPV system can be more straight forward regarding system theory analysis aspects like stability, observability, and/or controllability than a high-fidelity model simulated within the development tool. Thereby, also the controlling of the movement of the component of the mechatronic system may be improved, e.g., in terms of stability and/or accuracy.

Moreover, the coupling of (e.g., multiple) LPV systems (e.g., related to multiple components of a mechatronic system) may be straightforward due to the clear structure and the distinction between states, inputs and outputs, e.g., of each LPV system.

E.g., several rotational axes of a patient table, and/or of a C-arm may be considered as several individual components of the patient table, and/or the C-arm, as the mechatronic system. Rotations around the different axes may be jointly described as a (in particular coupled) LPV system.

The concept of affine LPV systems is known for decades. Nevertheless, the inventors are not aware of any commercial software that automatically derives an affine LPV system (as an example of the state space model system) based on high-fidelity model simulation (as example of the, in particular initial, set of state space models). Since the (e.g., input, output, and/or internal) parameters required to simulate an LPV systems have a clear physical and/or technical (also denoted as scientific) meaning, it would be very obvious if commercial software would use this concept to derive an alternative description of the same high-fidelity model.

A key aspect of the inventive technique lays not only in the fact of having derived one representation of the (in particular initial) set of state space models (and/or high-fidelity model) by means of a state space model system (in particular an affine LPV system), but also in deriving the optimal state space model system (in particular the optimal affine LPV system). Deriving the optimal state space model system (in particular the optimal affine LPV system) may in turn depend on (e.g., at least) two aspects which can be weighted problem specific. There is on the one hand simulation speed, and on the other hand accuracy. Alternatively or in addition, deriving the optimal state space model system (in particular affine LPV system) may be closely related to the layout of the scheduling space in general, and in particular to the number and placement of linearization points (and/or the set of operating points) in the scheduling space.

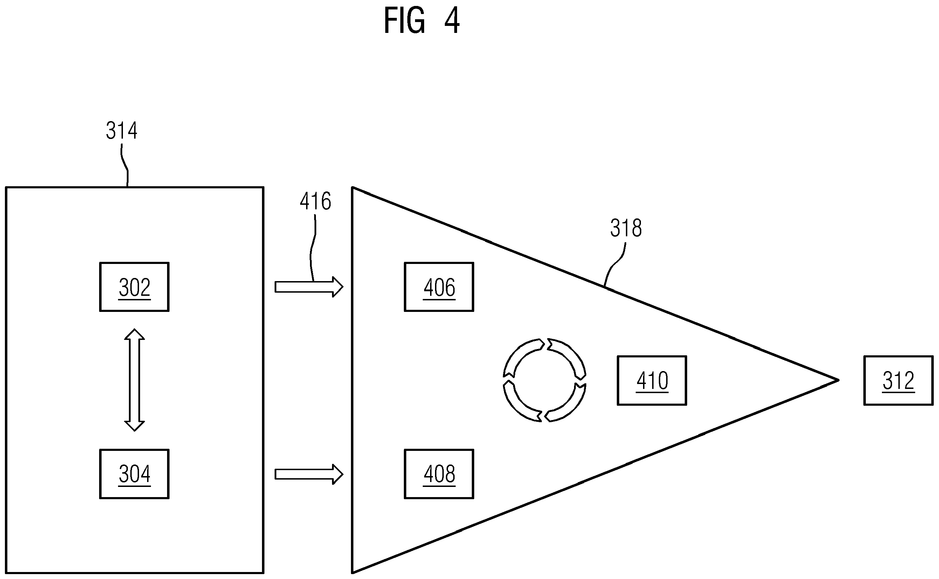

Fig. 4 provides a schematic illustration of the relationships between the initial set of state space models 306 (which may also be denoted as mechanical model, and/or high-fidelity simulation tool) and the deriving 416 (e.g., comprising, and/or corresponding to the method steps S106 of optimizing the initial set of state space models and S108 of assembling the state space model system) of the state space model system 406 (which may also be denoted as new mechanical model, and/or affine LPV system) in relation to the component of the mechatronic system 312. In the embodiment of Fig. 4, the component of the mechatronic system 312 is controlled by making use of the application software 410. In parallel to the initial set of state space models 306 (and/or mechanical model, and/or high-fidelity simulation tool), at the high level 314, the control system model 304 (which may also be denoted as domain specific tool) exists, and at the low level 318, a control system model 408 is provided (e.g., along with an affine LPV system as the state space model system).

The (e.g., component of the) mechatronic system 312 may also be denoted as mechatronic framework.

In one embodiment, the initial set of state space models 306 (and/or mechanical model, and/or high-fidelity simulation tool) may make use of conventional and/or commercial multi-body simulation software (also denoted as tool for high-fidelity mechanical simulation). Alternatively or in addition, the control system models 304 and 408 may make use of a (in particular dedicated) tool for control-system simulation, and/or, e.g., commercial, software for multi-domain simulation.

The application software 410 may be written in any programming language, e.g., in C, C++, C#, Java, and/or Fortran.

The inventive framework schematically indicated in Fig. 4 may have as key benefit that no re-engineering is required (e.g., if the mechatronic system 312 is repaired, upgraded, and/or extended), and/or that a developed workflow may be kept. Alternatively or in addition, the state space model system 406 (and/or the affine LPV system) may enable tool-independent simulations. Further alternatively or in addition, the simulations may be platform-independent. Still further alternatively or in addition, the complexity of the state space model system 406 (and/or the affine LPV system) may be scalable (e.g., according to requirements on the granularity of controlling the movement of the component of the mechatronic system 312), and/or the existing computing resources (e.g., comprising the processor and/or memory).

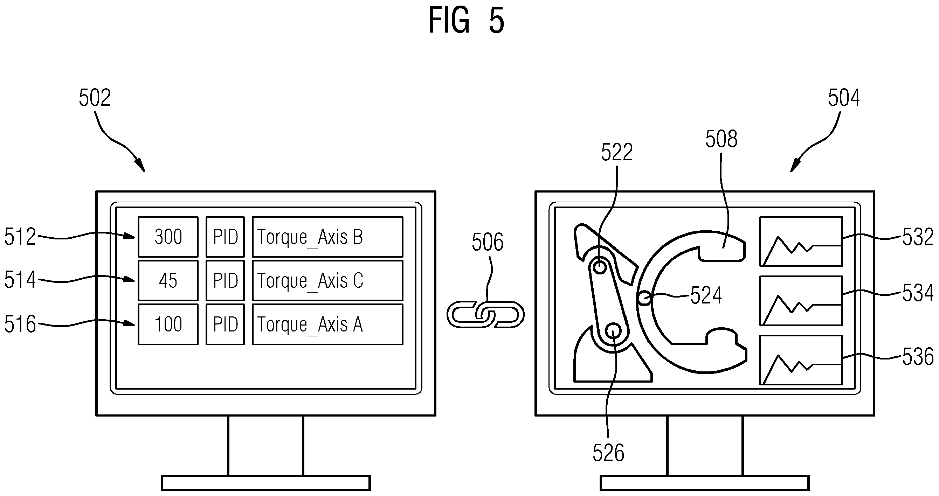

Figs. 5, 6 and 7 schematically illustrate an exemplary three step approach according to the inventive technique.

In Fig. 5 a first step of N-times coupling an initial set of state space models (also denoted as high-fidelity simulation) is shown (e.g., as the steps S102 of specifying the sets of input and output parameters and S104 of determining the initial set of state space models). Alternatively or in addition, N-times may refer to a number of simulations, which may lead to a set of N (e.g., coupled) state-space models.

Two displays 502 and 504 are exemplarily shown in Fig. 5, which are linked at reference sign 506. The display 502 schematically illustrates the use of three different input parameters 512; 514; 516 with associated values in the first column, the specification of the exemplary control-loop mechanism proportional-integral-derivative (PID) in the second column, and the type of (in particular physical, and/or technical) input parameter in the third column.

In the example of Fig. 5, a C-arm 508 as an example of a component of a mechatronic system has three axes of rotation 522; 524; 526 (also denoted as axis B, C, and A, respectively). Each axis of rotation has as input parameter a torque, as indicated in the third column at reference signs 512; 514; 516. The output parameters 532; 534; 536 per axis of rotation 522; 524; 526 are schematically indicated as function of the input parameter on the display 504. The output parameters 532; 534; 536 may, e.g., comprise a (in particular rotational) speed (and/or velocity), and/or a (e.g., change in) position of the C-arm 508.

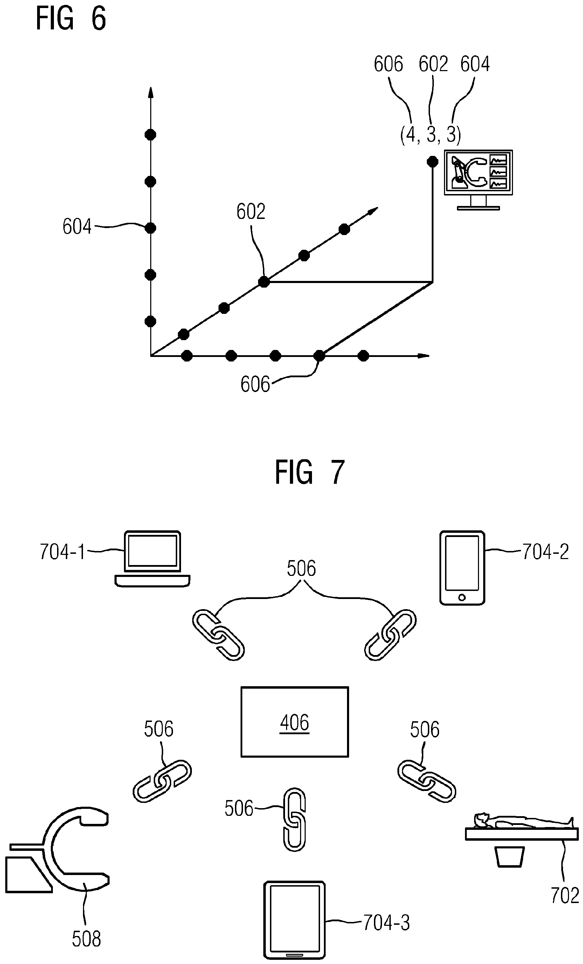

Fig. 6 exemplarily shows a discrete set of operational points. The exemplary triple (4,3,3) in Fig. 6 refers to a (e.g., dimensionless) choice of the input parameters 602; 604; 606, which in the example of Fig. 5 correspond to values of the torque of the rotational axes B; C; A at reference signs 512; 514; 516.

The scheduling space of the exemplary (e.g., affine) LPV system, e.g., in relation to the C-arm of Fig. 5, is built using a plurality of operational points. This second step of the exemplary three-step approach may comprise the steps S106 of optimizing the set of state space models, S108 of assembling the state space model system, and/or the optional step S110 of reducing the assembled state space model system.

Fig. 7 shows a tool-independent simulation of an affine LPV system 406 (e.g., as example of the state space model system). The exemplary embodiment of Fig. 7 shows a C-arm 508 and a patient table 702 as components of a mechatronic system, e.g., comprising a medical scanner. The simulation (e.g., comprising the steps S112 of receiving, in particular real, and/or operational, input parameters, applying S114 the affine LPV system 406, and at least one of the steps of outputting S118 or S118' a value or an indication of a crossing of a predetermined threshold of the output parameters, and/or controlling S119 the component of the mechatronic system) may be performed using any available hardware platform, e.g., a PC (and/or notebook) 704-1, a smartphone 704-2, and/or a tablet computer 704-3.

An exemplary workflow of an embodiment may comprise a specification phase for defining a (e.g., affine) LPV system and scheduling space, a simulation and optimization phase in the high-fidelity tool for gathering data and checking for relevant LTI-models based on non-linearity criteria, and an assembly phase of the (in particular affine) LPV system (also denoted as LPV model).

The specification phase may comprise defining inputs that drive the system, defining outputs of the system that may be of interest and defining an operational space of the mechanical system. The scheduling space may be spanned in each dimension, e.g., comprising a target number of local LTI-models in each dimension based on non-linearity. E.g., assuming three dimensions (e.g., each corresponding to rotations around one of the axes of the C-arm of Fig. 5), there might be 10x10x10=1000 local LTI-models.

The simulation and optimization phase in the high-fidelity tool may comprise driving the system through the scheduling space and gathering required LPV-data, check (e.g., each) LTI-model with respect to the level of non-linearity, and reducing the number of local LTI-models based on a non-linearity measure.

The assembly phase of LPV-model may comprise assembling the LPV system using the local LTI-models, offsets and initial states, and discretizing the LTI-models according to resolution requirements.

The above-described exemplary workflow may correspond to the steps S102 to S110 of the method 100. Alternatively or in addition, the above-described workflow may comprise a knowledge-based reduction of the size of an (e.g., affine) LPV system based on the introduction of thresholds in the time or/and frequency domain, e.g., comprising a time-domain based decision, a comparison of step responses, and/or a frequency domain based decision, e.g., comprising a comparison of transfer functions.

Fi. 8A provides a schematic illustration of a workflow in relation to an estimation of a patient weight based on the current flowing through the electric motor (briefly also e-motor) of an axis driven by the motor.

The prerequisite is a valid mechatronic substitute model - e.g. an extended LPV model (and/or affine LPV system) - which is operated in parallel to the hardware (e.g., in parallel to the mechatronic system).

An (e.g., affine) LPV system (also denoted as LPV model), e.g., for estimating a patient mass parameter 812, according to the inventive technique may have significant advantages in that the LPV system (and/or model) structure may be obtained from common (e.g., commercial and/or non-commercial) simulation programs in a standardized way, may be simulated independently of platform and/or independently of a tool, and the structure of parameter-dependent matrices (e.g., comprising a system matrix A(p), input matrix B(p), output matrix C(p) and continuity matrix D(p)) may be human-readable.

The (e.g., affine) LPV system (and/or LPV model) may be run, e.g., either on a hardware CPU or on a separate mini-PC, e.g., as schematically indicated in connection with Fig. 7.

The mechatronic replacement model (and/or the, in particular affine, LPV system) may be driven by the same signals as the hardware.

The starting point may be a calibrated mechatronic substitute model (e.g., an extended LPV model and/or, in particular affine, LPV system) parameterized with known patient masses.

Calibrated herein may mean that when an axis of the hardware is controlled, the same axis of the mechatronic substitute model executes a comparable movement with a comparable e-motor current of the e-motor that drives this axis.

The matrix structure of the extended LPV model (and/or the, in particular affine, LPV system) of the overall system may comprise the patient mass as a parameter.

As soon as the operator (also denoted as user) sends a control command 802 for an axis via a communication interface (e.g., a UI) to a controller 804, a motor current may generated in the further course of the signal flow, which causes the electric motor 806 to build up a torque that drives the axis according to the desired control command. The axis may be comprised in the mechanical system 808 (and/or mechatronic system) comprising a mechanical device 810 (and/or component) and associated patient mass 812. The (e.g., temporal course of the) motor current is stored at reference sign 805 and made available to the simulation model 822 in the later course.

A position sensor 814 detects the distance traveled and returns the information (e.g., on the travelled distance) to the motor controller 804 and a sensor signal comparator 828.

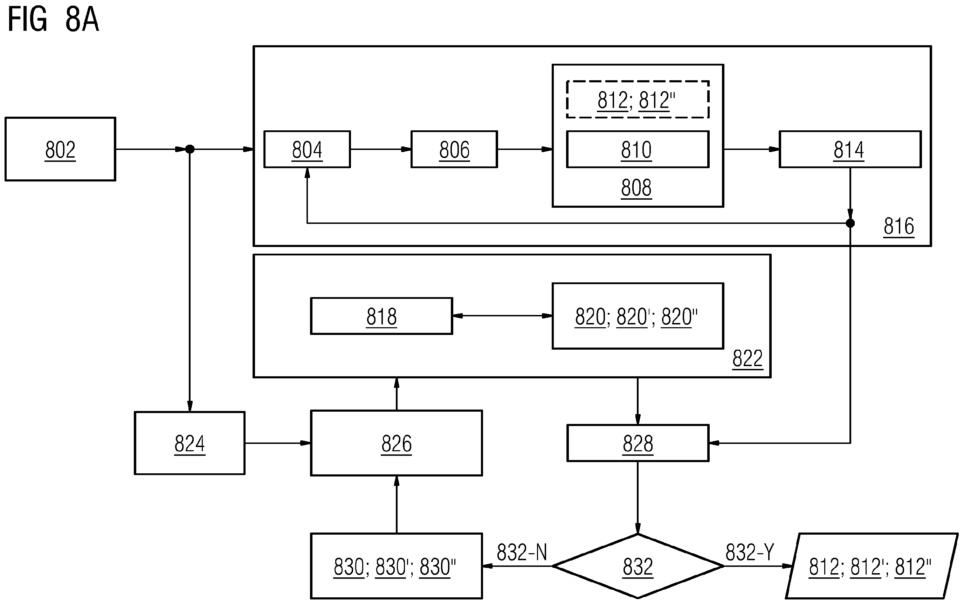

The upper block of Fig. 8A, as indicated at reference sign 816, comprises the hardware of the mechatronic system.

The middle block of Fig. 8A, as indicated at reference sign 822, comprises the simulation model (and/or state space model system, in particular the, e.g., affine, LPV system).

In Fig. 8A, the identical control command 802 is saved at reference sign 824 and sent to the simulation model 822, which is launched at reference sign 826. The simulation model 822 implements the control command 802 and also moves the corresponding axis.

At reference sign 818 in Fig. 8A, a motor controller model is implemented, and reference sign 820 denotes the LPV model (and/or, in particular affine, LPV system) comprising the patient mass and sensors (e.g., performing the position sensing at reference sign 814).

At reference sign 828 in Fig. 8A, sensor signals from the simulation model 822 and the hardware 816 are compared, and at reference sign 832 it is determined if the difference between the sensor signals is below a tolerance (and/or a predetermined threshold). If the difference of the sensor signals exceeds the tolerance (and/or the predetermined threshold), at reference sign 832-N, the workflow proceeds to adjust a patient mass parameter 830 and re-launches the simulation at reference sign 826. Alternatively or in addition, if the difference of the sensor signals is below the tolerance (and/or lower than the predetermined threshold), at reference sign 832-Y, the patient mass 812 is provided (e.g., output according the step S118) as a result.

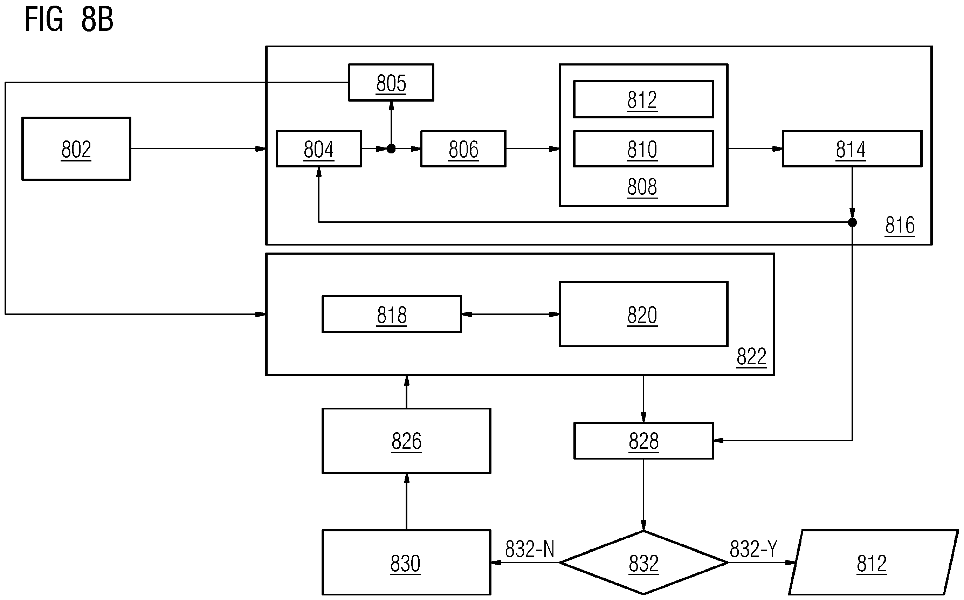

Alternatively or in addition, as depicted in Fig. 8B the previously stored motor current curve 805 can be imprinted directly on the simulation model 822.

The use of the stored motor current curve 805 may be understood synonymously to the control command, which results in a motor current.

The position information 814 of the moved axis of the simulation model may be provided to the comparison 828. The achieved travel distance may be compared to a result 820 of the identical motor torque.

Most likely, the two travels 814; 820 are not identical (e.g., as indicated at reference sing 832-N) because the patient mass parameter of the calibrated simulation model differs from the actual patient mass 812.

Now, the patient mass parameter of the simulation model 822, e.g., of the extended LPV model (and/or the, in particular affine, LPV system), may be varied 830 until the travel distance of the simulation model and the actual travel distance are identical (e.g., as indicated at reference sign 832-Y) as a result of the previously stored and now memorized motor current curve 805.

Once the patient mass parameter 812 has been identified, it may be communicated to the operator.

The simulation model 822, e.g., the extended LPV model (and/or the, in particular affine, LPV system), does not necessarily have to be real-time capable to estimate the patient weight 812.

A key point of the inventive technique is that the time history of an input signal to the hardware (e.g., a communication signal, a motor current, and/or a motor torque) may be used to iteratively drive a calibrated simulation model 822, such as an extended LPV model (and/or, in particular affine, LPV system), to determine the patient weight parameter 812.

The exemplary workflows Figs. 8A and 8B have been discussed above in connection with estimating a patient mass as output of an embodiment of the inventive state space model system.

According to an alternative embodiment, the inventive state space model system is used for estimating friction along a load path.

An increased friction level in a load path (e.g., of the component of the mechatronic system) is generally difficult to detect, since typically the combination of controller 804 and electric motor 806 has sufficient reserves to reliably approach a set position despite increased friction.

An increased friction level is nevertheless problematic, as it can be an indication of a defect, can lead to increased power consumption during operation, or/and can lead to increased wear.

According to the inventive technique, a mechatronic simulation model (e.g., extended LPV model, and/or, in particular affine, LPV system) is operated with the same test signal as the hardware.

A workflow diagram for estimating friction along a load path may be essentially identical to the workflow of estimating a patient mass, as schematically depicted in Fig. 8A. For the workflow of estimating the friction along the load path, the LPV model (and/or, in particular affine, LPV system) 820' may comprise a lumped friction (e.g., instead of a patient mass). The final output may comprise a lumped friction 812' (e.g., instead of the patient mass 812). The adjusting 830' may refer to adjusting a friction parameter (e.g., instead of adjusting 830 the mass parameter).

Sensing 814 of a position along the load path of interest due to the application of a defined test signal in the form of a motor current 805, and/or a motor torque, may be performed. Imposing the same test signal on a calibrated mechatronic simulation model 822 and comparing 828 the resulting position with the sensed 814 position of the hardware 816 may be performed.

A starting point and/or prerequisite of estimating a friction parameter may be a calibrated mechatronic simulation model 822 (e.g., extended LPV model, and/or, in particular affine, LPV system), as indicated in Fig. 8A.

Calibrated herein may mean that when an axis of the hardware is controlled, the same axis of the mechatronic simulation model 822 with comparable motor current 805 of the electric motor 806, and/or comparable motor torque, may be selected, which ultimately drives this axis and produces a comparable movement (e.g., of the component of the mechatronic system).

The simulation model 822 of the second embodiment may have a concentrated (and/or lumped) friction value along the axis on which the test signal acts in the form of a motor current 805, and/or a motor torque.

The mechatronic replacement model 822 (e.g., extended LPV model, and/or, in particular affine, LPV system) may operated in parallel to the hardware 816.

The LPV model (and/or in particular affine, LPV system) may be operated, e.g., either on the CPU of the hardware 816 or on a separate mini-PC, e.g., as exemplified in Fig. 7.

An LPV model (and/or, in particular affine, LPV system), in particular for estimating a friction parameter 812', according to the inventive technique may have significant advantages in that the model (and/or system) structure may be obtained from common (e.g., commercial and/or non-commercial) simulation programs in a standardized way, may be simulated independent of platform and tool, and the structure of parameter-dependent matrices (e.g., comprising a system matrix A(p), input matrix B(p), output matrix C(p) and continuity matrix D(p)) may be human-readable.

The software structure of the extended LPV model (and/or, in particular affine, LPV system) of the whole (e.g., mechatronic) system may comprise the concentrated (and/or lumped) friction value as a parameter 812', which can describe a more complex (e.g., non-linear) friction function.

Since the mechatronic simulation model 822 is calibrated, the impressed test signal in the form of a defined motor current 805, and/or motor torque, leads to the same movement (also denoted as motion) as the hardware 816. The movement may be translatory, and/or rotatory.

If a target position (e.g., converted to a motor current 805, and/or motor torque) is exceeded with the calibrated simulation model 822, an increased friction level 812' in the hardware 816 may be indicated according to the workflow of Fig. 8A.

The operator may be informed about the anomaly and, e.g., a service and/or maintenance department may be informed.

Furthermore, it may be possible to estimate the friction value 812' of the hardware 816 by (e.g., always) impressing the test signal on the calibrated simulation model 822 and iteratively varying 830' the concentrated (and/or lumped) friction value of the simulation model 822 until the sensed position 814 of an axis of the hardware 816 and the position of the same axis of the simulation model 822 provide comparable values.

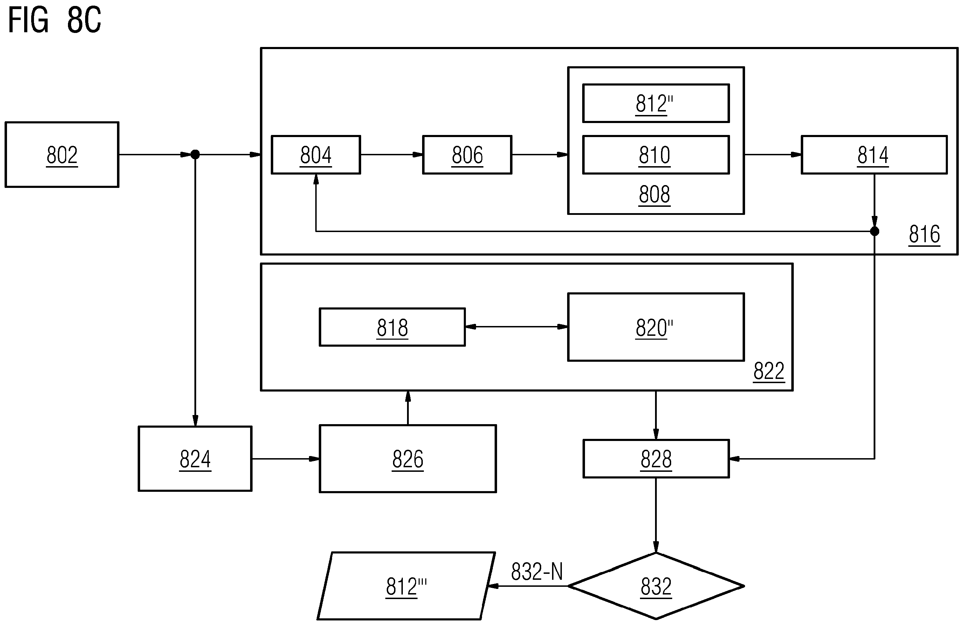

According to a further embodiment, a patient motion may be detected by means of the inventive technique. This embodiment is described in the context of the workflows of Fig. 8A and 8C.

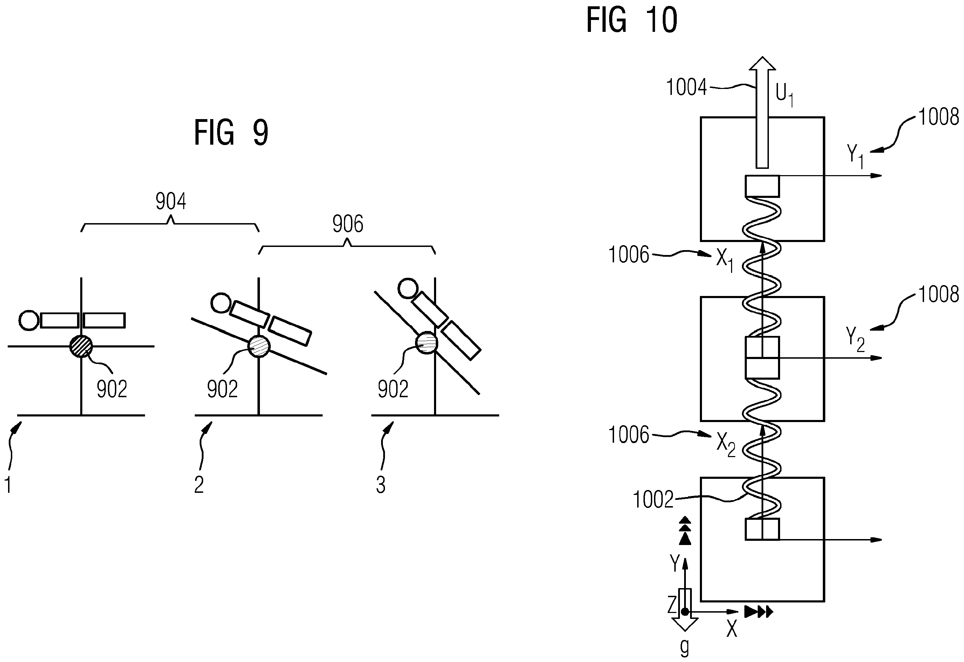

According to the workflow of Fig. 8A, a rotation by a small angle, as indicated at reference sign 904 in Fig. 9, from position 1 to position 2 for patient inertia 812'' identification may be applied.

According to the workflow of Fig. 8C, a rotation by a large angle, as indicated at reference sign 906 in Fig. 9, from position 2 to position 3 may be monitoring to detect a motion (e.g., of the patient).

The rotations of the patient table in Fig. 9 may be perform around the rotational axis at reference sign 902.

The patient motion, and/or patient positioning, may be estimated (e.g., according to the workflows schematically illustrated in Figs. 8A and 8C) based on the current 805 flowing through the electric motor 806 of an axis driven by the motor 806.

As soon as the operator sends a communication command 802, and/or control command 802, to the controller 804 for an axis (e.g., via the communication interface, in particular the UI, and/or GUI), a motor current 805 may be generated, which may causes the electric motor 806 to build up a torque that drives the axis according to the desired control command 802, e.g., from position 1 to position 2, and/or further to position 3 in Fig. 9.

It is conceivable that the patient changes his, or her, position on the patient table, e.g., when moving from position 2 to position 3, as indicated at reference sign 906 in Fig. 9. The change of the patient position may be undesirable. A sensor, which conventionally detects the patient table position, may not be able to detect the change in the patient position.

A calibrated mechatronic simulation model 822 running in parallel according to the inventive technique, may be used to detect the relative position change of the patient on the patient table.

The relative motion between patient and patient table is conventionally difficult to sense because typically the position of (e.g., only) the patient table is sensed.

According to the inventive technique, a mechatronic simulation model 820'' (e.g., extended LPV model, and/or, in particular affine, LPV system) comprising a patient inertia (and/or associated sensor values) may be run with the same input signal as the hardware 816.

The relevant parameter moment of inertia, in particular the patient's moment of inertia 812'' about the axis of rotation, may be obtained iteratively from the simulation model 822. The patient inertia 812'' may be stored.

Subsequently, in the course of further patient table rotations, it may be checked 828 whether in each case the subordinate mechatronic substitute model 822 leads to identical output-side rotation angles with an identical input signal compared to the hardware.

At reference sign 830'', the patient inertia parameter may be adjusted, if a deviation is detected at reference sign 832-N.

Alternatively or in addition, the operator may be informed if the angle deviation between hardware 816 and simulation model 822 (also denoted as modelware) exceeds a threshold value.

The prerequisite is a valid mechatronic substitute model 822 (e.g., an extended LPV model, and/or a, in particular affine, LPV system) which is operated in parallel to the hardware 816.

An LPV model (and/or a, in particular affine, LPV system), in particular for detecting a patient motion, according to the inventive technique may have significant advantages, since the model (and/or system) structure may be obtained from common (e.g., commercial and/or non-commercial) simulation programs in a standardized way, may be simulated independently of platform and/or tool, and/or the structure of parameter-dependent matrices (e.g., comprising a system matrix A(p), input matrix B(p), output matrix C(p) and continuity matrix D(p)) may be human-readable.

The LPV model (and/or, in particular affine, LPV system) may be run, e.g., either on the hardware CPU, and/or on a separate mini-PC, e.g., as schematically illustrated in Fig. 7.

Furthermore, the mechatronic replacement model 822 may be controlled with the same signals as the hardware 816.

The starting point may be a calibrated mechatronic substitute model 820'' (e.g., an extended LPV model and/or a, in particular affine, LPV system), which may allow parameterization of the inertia tensor of the patient model.

Calibrated may denote that with identical control of an axis of the hardware 816, the same axis of the mechatronic substitute model 820" executes a comparable movement.

The matrix structure of the extended LPV model (and/or, in particular affine, LPV system) of the overall (e.g., mechatronic) system may comprise the (e.g., entire) inertia tensor of the patient model, which may be simplified and/or assumed to be a rigid body.

In the embodiment of detecting the change of the patient's position on the patient table, the axis 902 of interest may be the axis of a medical device (e.g., a medical scanner comprising the patient table) 810, which rotates the patient table on which the patient lies.

Fig. 8A schematically illustrates a step, in which the moment of inertia 812" of the patient relative to the axis of rotation of the patient table is estimated. For this purpose, a small motor current 805 may be applied to the corresponding axis 902 of the hardware 816, which rotates the patient table including the patient by a small angle. The simulation model 822, and/or the modelware, may be energized (e.g., using the motor controller model 818) analogously to the hardware.

Despite the assumed calibration, there may be deviations 832-N regarding the sensed position 814 between hardware 816 and modelware 822, because the patient's moment of inertia 812" is (e.g., a priori) unknown.

The parameter moment of inertia 812" of the patient model may be varied 830" in the mechatronic replacement model 820". A new simulation may be performed with the original temporal course of the motor current 805. Afterwards, the achieved target position of hardware 816 and modelware 820" is compared (e.g., again).

If a threshold value has now been undershot with regard to the comparison, as indicated at reference sign 832-Y in Fig. 8A, the identified moment of inertia 812" may be stored for further analysis.

As schematically indicated in Fig. 8C, larger motor currents may subsequently be applied on the hardware 816, which in turn lead to larger rotations (e.g., as indicated at reference sign 906 in Fig. 9) of the patient table.

The larger rotation, and/or the larger applied motor current, may increase the risk of a relative displacement (and/or a relative motion) between the patient and the patient table.

To detect the relative displacement (and/or relative motion) between the patient and the patient table, the calibrated extended simulation model may be used. The detecting of the relative displacement (and/or relative motion) may comprise making use of the previously identified moment of inertia 812" of the patient, which may be a constant.

The calibrated extended simulation model 820" may receive the same control commands (and/or communication commands) 802 (e.g., by saving the control command, and/or communication command, at reference sign 824 and subsequently launching the simulation at reference sign 826) and thus motor currents as the hardware 816.

The simulation model 822 may result in comparable rotation angles to the hardware 816.

If the simulation model 822 does not result in comparable rotation angles to the hardware 816, as indicated at reference sign 832-N in Fig. 8C, there must have been a change in the total moment of inertia 812" of the (e.g., combined) patient table and patient. The change may have occurred because the patient has changed position relative to the patient table, which affects the total moment of inertia 812" of the (e.g., combined) patient table and patient, which in turn affects the response of the (e.g., mechatronic) system to a motor current.

If the rotational angle difference of the hardware and modelware exceeds a predetermined threshold (and/or tolerance), the operator of the hardware may be informed, as indicated at reference sign 832-N in Fig. 8C, that a movement 812''' of the patient relative to the patient table has occurred.

In any embodiment, the simulation model 822 of Figs. 8A, 8B and 8C may be identical to the state space model system 406 of Fig. 4.

Fig. 10 shows an exemplary embodiment of a state space model system (e.g., for a spring 1002). The state space comprises input parameters 1004 (e.g., denoted as $U_1$) driving the system, states 1006 (e.g., denoted as $x_1$ and $x_2$) describing the system, and output parameters 1008 of interest (e.g., denoted as $y_1$ and $y_2$).

A first embodiment of the state space model system may comprise a linear state-space model (e.g., corresponding to a linear spring with two degrees of freedom, as schematically illustrated in Fig. 10), which may be described by the following set of equations:

$$\dot{x}(t) = A\,x(t) + B\,u(t),$$

$$y(t) = C\,x(t) + D\,u(t),$$

$$x(0) = x_o.$$

$x(t)$ may denote the state vector (and/or internal quantity), $y(t)$ may denote the output vector, and $u(t)$ may denote the input (and/or control) vector (and/or external drive).

The matrix $A$ may denote the state (and/or system) matrix, the matrix $B$ may denote the input matrix, the matrix $C$ may denote the output matrix, and the matrix $D$ may denote the feedthrough (and/or feedback) matrix.

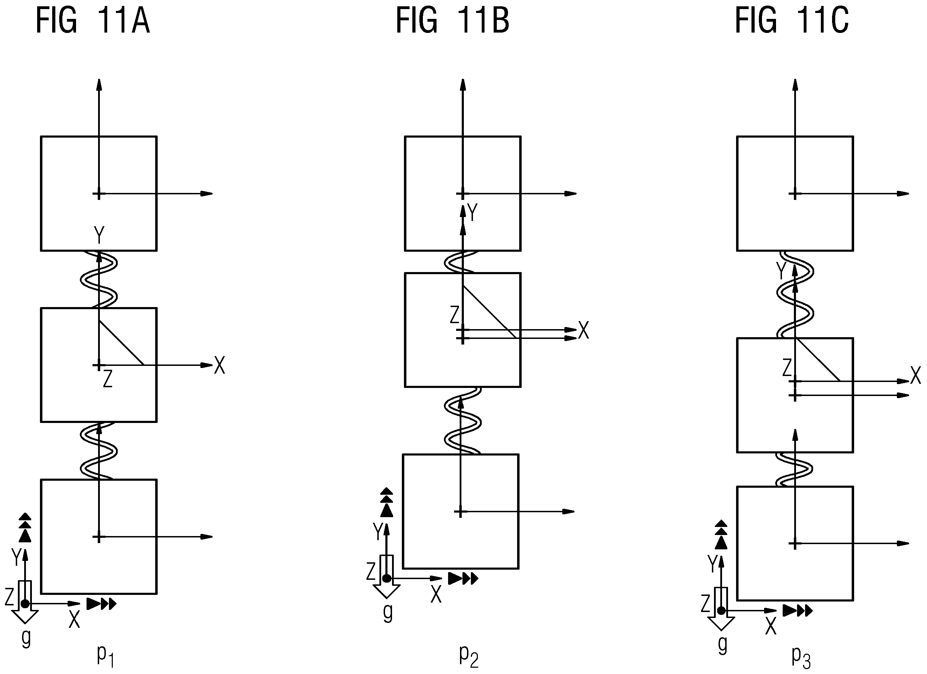

A second embodiment of the state space model system may comprise an LPV system (e.g., corresponding to a non-linear spring with two degrees of freedom, as schematically illustrated in Figs. 11A, 11B and 11C), which may be described by the following set of equations:

$$\dot{x}(t) = A(p)\,x(t) + B(p)\,u(t),$$

$$y(t) = C(p)\,x(t) + D(p)\,u(t),$$

$$x(0) = x_o.$$

The entries of the matrices $A(p), B(p), C(p)$ and $D(p)$ depend on the operating point, which is $p_1$ in Fig. 11A, $p_2$ in Fig. 11B, and $p_3$ in Fig. 11C.

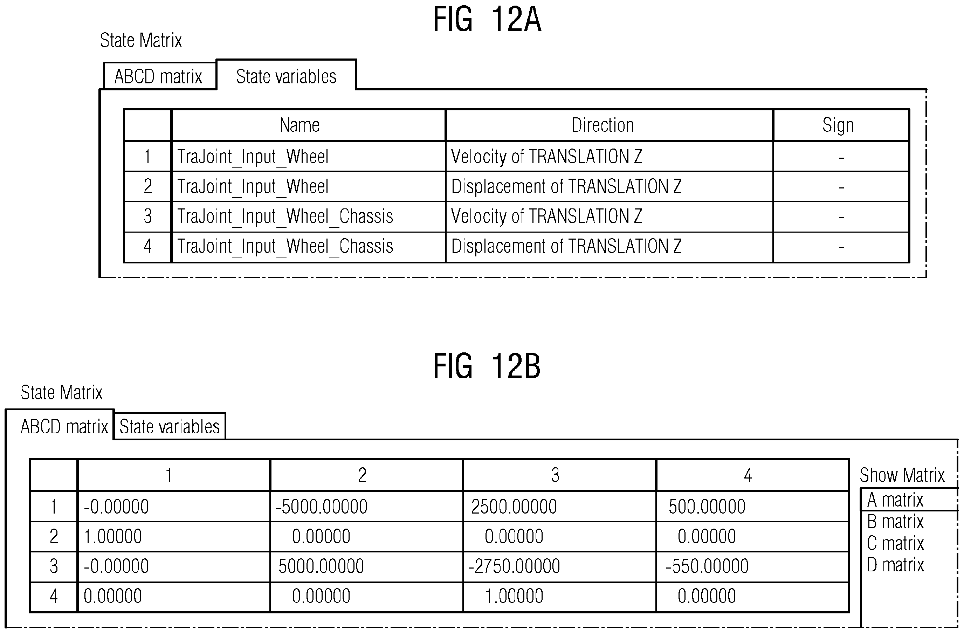

Figs. 12A and 12B show exemplary entries of state variables (e.g., comprising velocities and/or displacements in relation to translations) and the A, B, C, D matrices, respectively, at one operating point.

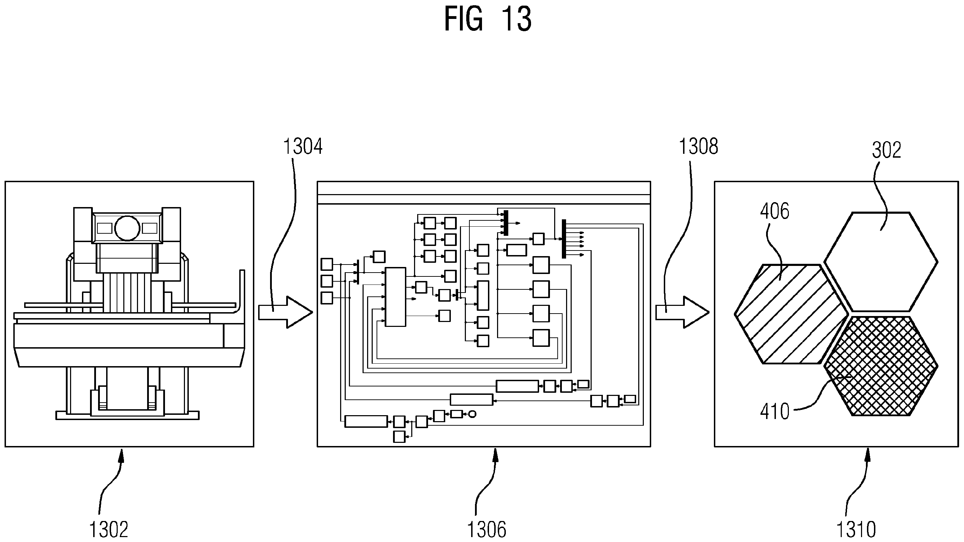

Fig. 13 schematically illustrates a workflow in relation to a, in particular real-time simulation of a, patient table as the component of a mechatronic system (e.g., comprising a medical scanner). At reference sign 1302, a non-linear multi-body (mb) simulation is performed, e.g., using a, in particular commercial, multi-body simulation software. At reference sign 1304, the nonlinear mb-simulation is transformed into one or more state space models (and/or a linearization is performed at various operating points). As a result, at reference sign 1306, a fixed step state-space simulation, e.g., in a (in particular commercial) software for multi-domain simulation , is obtained. At reference sign 1308, a C-code export is performed to arrive, at reference sign 1310, at the characteristic inventive combination of the mechatronic component model 406, the high-fidelity multi-body model 302, and the application software 410 (e.g., as described in the context of Fig. 4).

Three axes of the exemplary patient table of Fig. 13 may be driven by torques, with the remaining axes constrained (e.g., by the first three axes).

E.g., a (in particular commercial) software for multi-domain simulation model may orchestrate the LPV system of Fig. 13 to cover non-linearities.

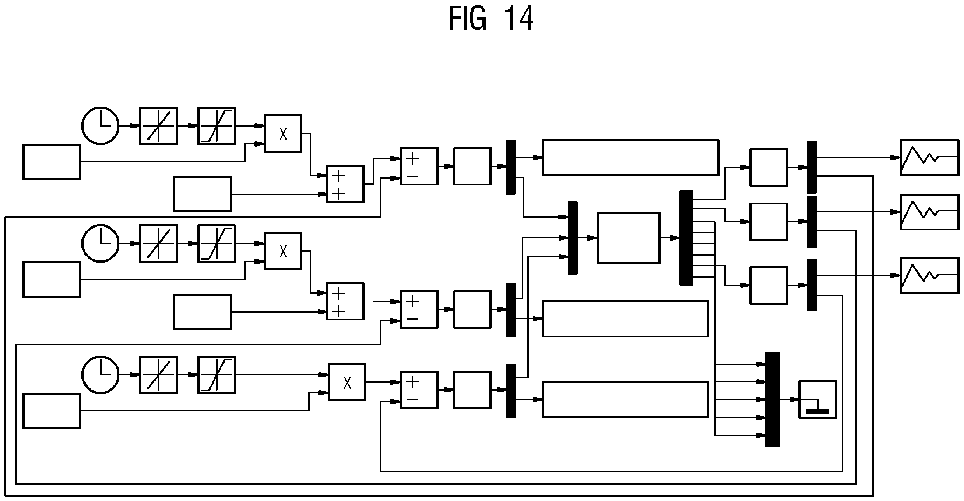

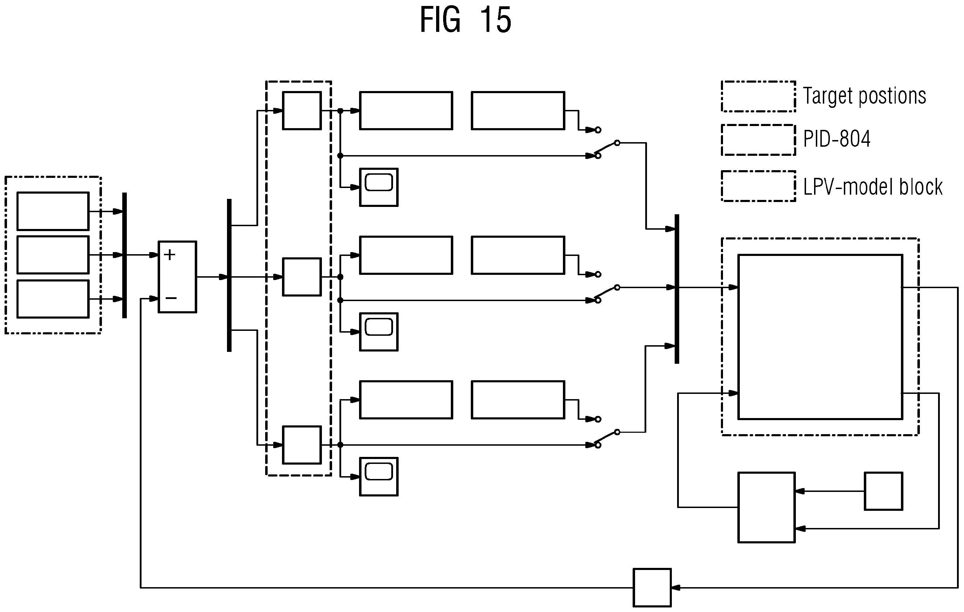

The workflow in relation to the patient table of Fig. 13 may be analogous to the one described in Figs.5, 6 and 7 for the C-arm. E.g., as indicated in Fig. 14, a coupled non-linear simulation may be performed, in particular a (e.g., commercial) multi-body simulation software, as first step. The second step of building one or more LPV systems in scheduling space may correspond to the step described in connection with Fig. 6. In a third step, as schematically indicated in Fig. 15 the one or more LPV systems may be operated, e.g., using the (in particular commercial) software for multi-domain simulation.

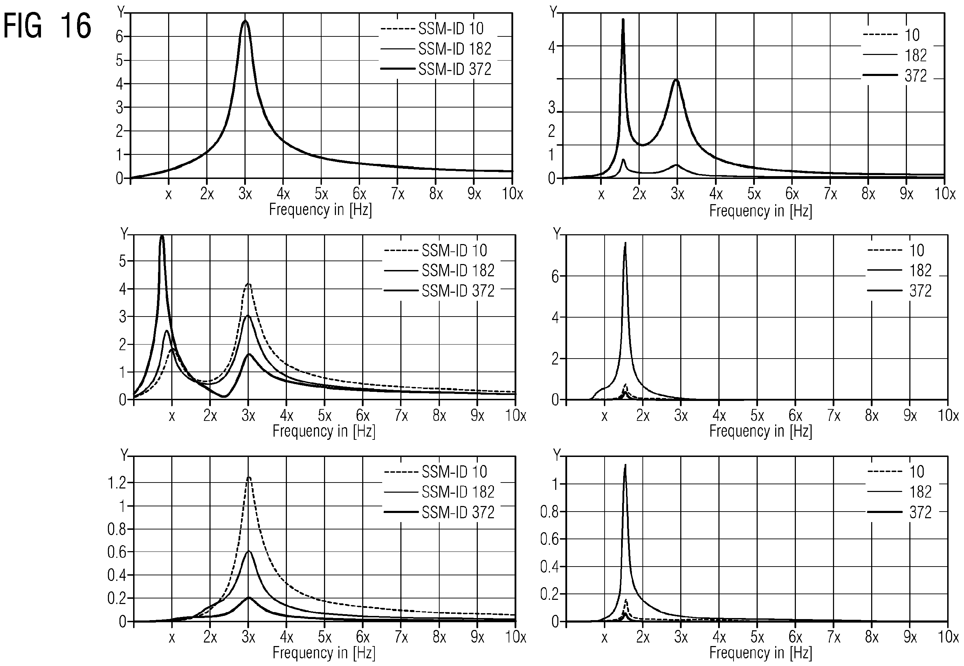

Fig. 16 schematically illustrates a phase of verification (e.g., of the one or more LPV system), in which a transfer function for input at axis A (left) and axis B (right) is plotted against a frequency.

In Fig. 16, the three rows correspond to three outputs (e.g., of the one or more LPV systems). E.g., an angle of rotation at (and/or around) a first axis (e.g., axis A at reference sign 526 in Fig. 5) corresponds to the first row, an angle of rotation at (and/or around) a second axis (e.g., axis B at reference sign 522 in Fig. 5) corresponds to the second row, and an angle of rotation at (and/or around) a third axis (e.g., axis C at reference sign 524 in Fig. 5) corresponds to the third row.

As visible in Fig. 16, a motion of axis is plotted vs. an input torque. Exemplarily, 372 operating points in scheduling space have been considered with the transfer function applied at the operating points. As clearly visible in all plots of Fig. 16, the dependence of the motion of the axis on the applied input torque is non-linear.

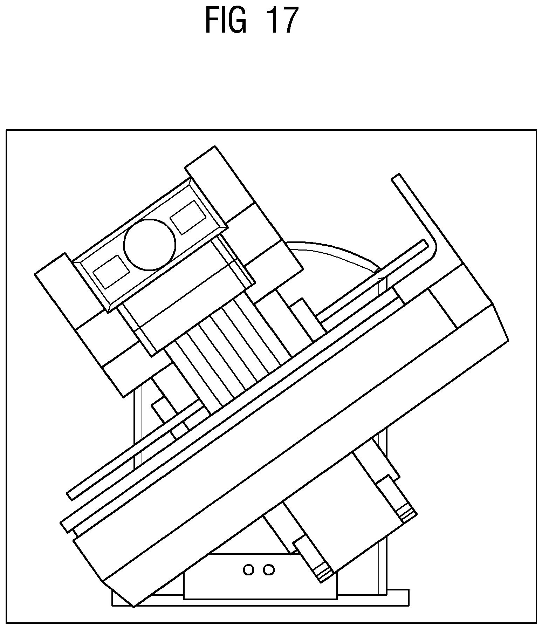

Fig. 17 further schematically illustrates the verification (e.g., of the one or more LPV system). The patient table of Fig. 13 is rotated (e.g., relative to a neutral, and/or idle, position) in Fig. 17, e.g., with motion parameters rot=+35x, lift=+300x, long=-100x.

The motion parameters in Fig. 17 highlight (and/or specify, and/or correspond to) one point in scheduling space. This point in scheduling space, e.g., comprises 35deg of a table-rotation, +300mm of a table-lift motion and -100mm of a longitudinal table motion.

The state-space model (and/or the state space model system, in particular the LPV system) comprising its offset parameters may be extracted at the point in scheduling space (e.g., as depicted in Fig. 17) from a (e.g., commercial) tool, and/or (e.g., commercial, and/or simulation) software.

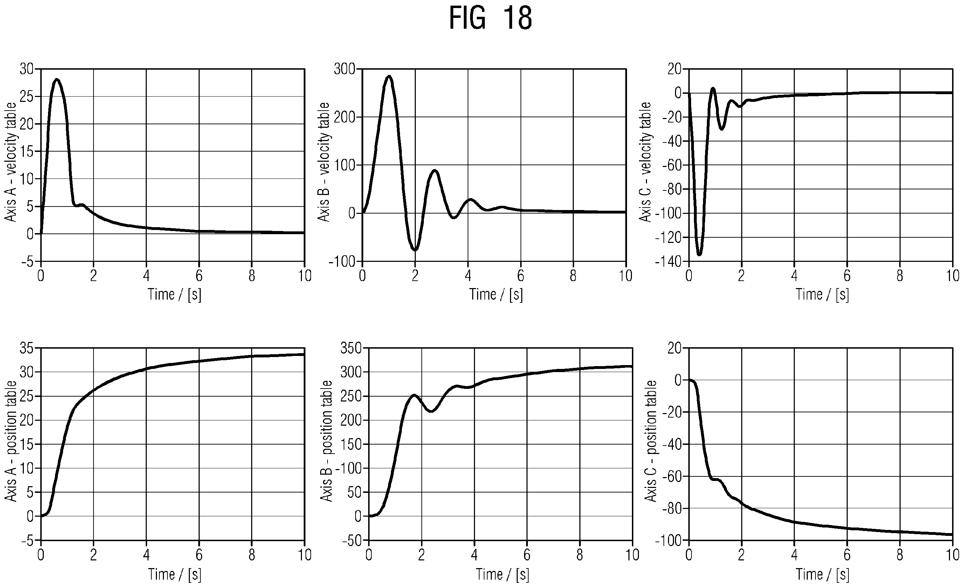

Fig. 18 schematically indicates the behavior of a nonlinear solver using a (e.g., commercial) multi-body simulation software, and/or a fixed-step solver in a (e.g., commercial) software for multi-domain simulation. In Fig. 18, a velocity (upper row) and a position (lower row), and/or a corresponding displacement (lower row), of the patient table for three different axes (one per column) are plotted against time. The trajectories, and/or outputs originating from the non-linear solver (in particular of the commercial tool) match the analogous (and/or same) trajectories calculated by the fixed-step solver applied to the derived LPV-system.

Simulations using a (e.g., commercial) multi-body simulation software versus simulations using a (e.g., commercial) software for multi-domain simulation may be used for describing a combined motion in open-loop configuration.

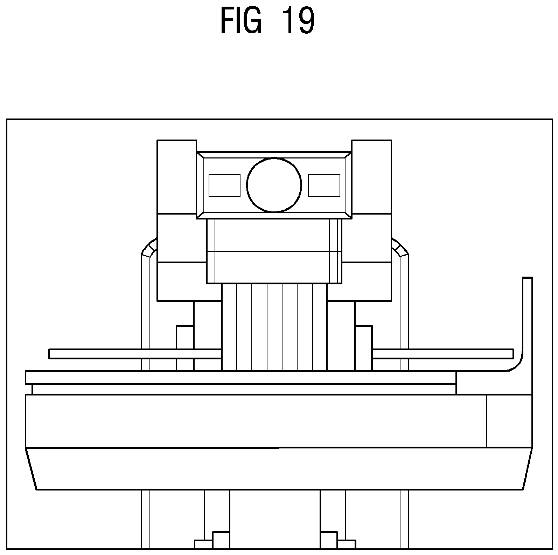

Fig. 19 exemplifies a step of validation (e.g., of the one or more LPV systems) for a long table. A fixed-step simulation, in particular by means of a (e.g., commercial) software for multi-domain simulation, versus a measurement may be performed.

The one or more LPV-model IDs (and/or, in particular affine, LPV system IDs) may vary while table moves. An identification of inertias of gear shafts, and/or of the underlying physics of friction may be performed.

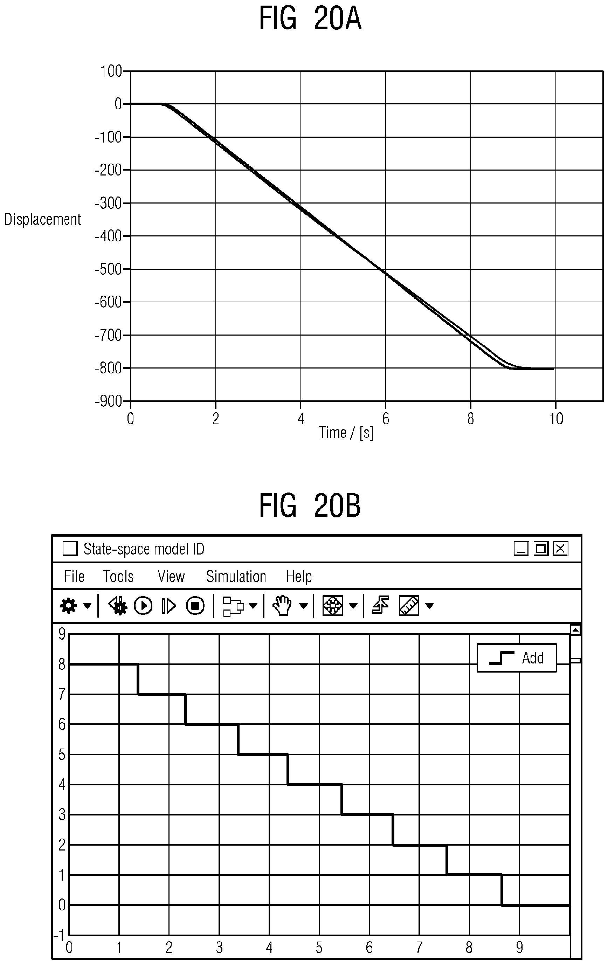

Figs. 20A and 20B show measurement and simulation data, in particular by means of a (e.g., commercial) software for multi-domain simulation, of displacements versus time as well as the corresponding LPV-model ID (and/or LPV system ID) used for the time steps.

The inventive technique can enable a seamless workflow, e.g., from a (in particular commercial) multi-body simulation software to a (in particular commercial) software for multi-domain simulation. Alternatively or in addition, the seamless workflow may be numerically stable, e.g., in parallel with scalable simulation speed.

The inventive technique may be applicable for multi-physics models of any kind. The concept may be very fruitful from a system theory point of view applied a movement of a component of mechatronic system. Simulation results may be validated against measurements.

Wherever not already described explicitly, individual embodiments, or their individual aspects and features, described in relation to the drawings can be combined or exchanged with one another without limiting or widening the scope of the described invention, whenever such a combination or exchange is meaningful and in the sense of this invention. Advantages which are described with respect to a particular embodiment of present invention or with respect to a particular figure are, wherever applicable, also advantages of other embodiments of the present invention.

**Claims**

1. Computer implemented method (100) of assembling a state space model system for controlling a movement of a component of a mechatronic system, the method comprising the steps of:

   - Specifying (S102) a set of input parameters for controlling a movement of a component of a mechatronic system and a set of output parameters for an initial set of state space models;
   - Determining (S104) the initial set of state space models by mapping multiple sets of values of the specified (S102) set of input parameters to multiple associated sets of values of the specified (S102) set of output parameters;
   - Optimizing (S106) the determined (S104) initial set of state space models by identifying (S106-1) approximately linear regions and (S106-2) selecting one state space model per approximately linear region, wherein the approximately linear regions comprise regions in a parameter space of the initial set of state space models, wherein the parameter space comprises the set of input parameters and the set of output parameters; and
   - Assembling (S108) the selected (S106-2) state space models per approximately linear region for obtaining a state space model system for controlling the movement of the component of the mechatronic system.

2. Method (100) according to claim 1, wherein at least one, or each, state space model within the determined (S104) initial set of state space models comprises a linear time-invariant, LTI, model.

3. Method (100) according to any of the preceding claims, wherein the assembled (S108) state space model system comprises a, in particular affine, linear parameter varying, LPV, system.

**4.** Method (100) according to any of the preceding claims, further comprising the step of:

- Reducing (S110) the assembled (S108) state space model system according to a predetermined threshold of a resolution.

**5.** Method (100) according to any of the preceding claims, further comprising at least one of the steps of:

- Receiving (S112) a further set of values of the set of input parameters, in particular from a controller of the component of the mechatronic system;
- Applying (S114) the assembled (S108), and/or the reduced (S110), state space model system to the received (S112) further set of values of the set of input parameters and obtaining (S116) an associated further set of values of the set of output parameters;
- Outputting (S118) the obtained (S116) associated further set of values of the set of output parameters;
- Outputting (S118') an indication of at least one value of the further set of values of the set of output parameters crossing a predetermined threshold;
- Controlling (S119), based on the obtained (S116) and/or the output (S118) associated further set of values of the set of output parameters and/or based on the output (S118') indication of the crossing of the predetermined threshold, the movement of the component of the mechatronic system; and
- Initiating (S120), responsive to the obtained (S116) and/or the output (S118) associated further set of values of the set of output parameters and/or responsive to the output (S118') indication of the crossing of the predetermined threshold, a maintenance procedure of the component of the mechatronic system.

**6.** Method (100) according to the directly preceding claim, wherein the predetermined threshold comprises a distance travelled by the component, a time until a predetermined position is reached by the component, and/or a frequency response by the component.

**7.** Method (100) according to any of the preceding claims, wherein the component of the mechatronic system is selected from the group of:

- A patient table;
- A C-arm;
- A drive system;
- A gearing mechanism; and
- A pulley.

**8.** Method (100) according to any of the preceding claims, wherein the set of input parameters comprises a motor control command, in particular a motor current, and/or a motor torque.

**9.** Method (100) according to any of the preceding claims, wherein the set of output parameters comprises an estimation of at least one of:

- A load;
- A mass;
- A force;
- a friction;
- a distance travelled; and
- a rotation angle.

**10.** Method (100) according to any of the preceding claims, wherein the specifying (S102) of the set of input parameters and the set of output parameters, and/or the receiving (S112) of the further set of values of the set of input parameters, comprises receiving an input from a user interface, UI.

**11.** Method (100) according to any of the preceding claims, wherein the initial set of state space models is based on a, in particular non-linear, mechanical model.

**12.** Method (100) according to any of the preceding claims, wherein the movement of the component comprises a translation, and/or a rotation, of the component.

13. Computing device (200) for assembling a state space model system for controlling a movement of a component of a mechatronic system, the computing device (200) comprising:

- A specifying module (202) configured for specifying a set of input parameters for controlling a movement of a component of a mechatronic system and a set of output parameters for an initial set of state space models;
- A determining module (204) configured for determining the initial set of state space models by mapping multiple sets of values of the specified set of input parameters to multiple associated sets of values of the specified set of output parameters;
- An optimizing module (206) configured for optimizing the determined initial set of state space models by identifying approximately linear regions and selecting one state space model per approximately linear region, wherein the approximately linear regions comprise regions in a parameter space of the initial set of state space models, wherein the parameter space comprises the set of input parameters and the set of output parameters; and
- An assembling module (208) configured for assembling the selected state space models per approximately linear region for obtaining a state space model system for controlling the movement of the component of the mechatronic system.

14. Computing device (200) according to the directly preceding claim, wherein the computing device (200) is further configured to perform anyone of the steps, or comprise anyone of the features, of the method claims 2 to 12.

15. System for assembling a state space model system for controlling a movement of a component of a mechatronic system, the system comprising:

- A computing device (200) according to claim 13 or 14; and
- At least one component of a mechatronic system, the movement of which is controlled by the computing device (200).

16. A computer program product comprising program elements which induce a computing device (200) to carry out the steps of the method of assembling a state space model system for controlling a movement of a component of a mechatronic system according to one of the preceding method claims, when the program elements are loaded into a memory of the computing device (200).

17. A computer-readable medium on which program elements are stored that can be read and executed by a computing device (200), in order to perform steps of the method of assembling a state space model system for controlling a movement of a component of a mechatronic system according to one of the preceding method claims, when the program elements are executed by the computing device (200).

FIG 1

100

S102

S104

S106-1 → S106-2    S106

S108

S110

S112

S116

S114

S118    S118'

S119    S120

FIG 2

# FIG  3

(PRIOR ART)

# FIG 4

FIG 5

# FIG 6

606 602 604

(4, 3, 3)

604

602

606

# FIG 7

704-1

704-2

506

406

506

506

506

508

506

704-3

702

FIG 8A

EP 4 455 802 A1

FIG 8B

EP 4 455 802 A1

# FIG 8C

EP 4 455 802 A1

EP 4 455 802 A1

FIG 9

FIG 10

FIG 11A

FIG 11B

FIG 11C

$p_1$

$p_2$

$p_3$

EP 4 455 802 A1

# FIG 12A

State Matrix

| ABCD matrix | State variables |

| | Name | Direction | Sign |
|---|---|---|---|
| 1 | TraJoint_Input_Wheel | Velocity of TRANSLATION Z | - |
| 2 | TraJoint_Input_Wheel | Displacement of TRANSLATION Z | - |
| 3 | TraJoint_Input_Wheel_Chassis | Velocity of TRANSLATION Z | - |
| 4 | TraJoint_Input_Wheel_Chassis | Displacement of TRANSLATION Z | - |

# FIG 12B

State Matrix

| ABCD matrix | State variables |

| | 1 | 2 | 3 | 4 | Show Matrix |
|---|---|---|---|---|---|
| 1 | -0.00000 | -5000.00000 | 2500.00000 | 500.00000 | A matrix |
| 2 | 1.00000 | 0.00000 | 0.00000 | 0.00000 | B matrix |
| 3 | -0.00000 | 5000.00000 | -2750.00000 | -550.00000 | C matrix |
| 4 | 0.00000 | 0.00000 | 1.00000 | 0.00000 | D matrix |

EP 4 455 802 A1

# FIG 13

EP 4 455 802 A1

FIG 14

FIG 15

Target postions

PID-804

LPV-model block

EP 4 455 802 A1

FIG 16

EP 4 455 802 A1

# FIG 17

# FIG 18

EP 4 455 802 A1

# FIG 19

# FIG 20A

# FIG 20B

Europäisches
Patentamt

European
Patent Office

Office européen
des brevets

# EUROPEAN SEARCH REPORT

**Application Number**

EP 23 16 9445

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/372091 A1 (LARIMORE WALLACE [US]) 18 December 2014 (2014-12-18) | 1-4,6-17 | INV. G05B13/04 G05B19/19 G05B19/416 |
| A | * abstract * * figures * * paragraph [0007] * * paragraph [0031] - paragraph [0041] * * paragraph [0076] - paragraph [0080] * * paragraph [0104] - paragraph [0110] * * paragraph [0196] - paragraph [0229] * ----- | 5 | |
| X | BART PAIJMANS ET AL: "Identification of Interpolating Affine LPV Models for Mechatronic Systems with one Varying Parameter", EUROPEAN JOURNAL OF CONTROL, vol. 14, no. 1, 1 January 2008 (2008-01-01), pages 16-29, XP055081860, ISSN: 0947-3580, DOI: 10.3166/ejc.14.16-29 | 1-4,6-17 | |
| A | * the whole document * ----- | 5 | TECHNICAL FIELDS SEARCHED (IPC) G05B |
| X | JAN DE CAIGNY ET AL: "Interpolation-Based Modeling of MIMO LPV Systems", IEEE TRANSACTIONS ON CONTROL SYSTEMS TECHNOLOGY, IEEE SERVICE CENTER, NEW YORK, NY, US, vol. 19, no. 1, 1 January 2011 (2011-01-01), pages 46-63, XP011340330, ISSN: 1063-6536, DOI: 10.1109/TCST.2010.2078509 | 1-4,6-17 | |
| A | * the whole document * ----- -/-- | 5 | |

The present search report has been drawn up for all claims

| Place of search | Date of completion of the search | Examiner |
|---|---|---|
| The Hague | 4 October 2023 | Abbing, Ralf |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

# EUROPEAN SEARCH REPORT

Application Number

EP 23 16 9445

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | PETER SIVK ET AL: "State-Space Model of a Mechanical System in MATLAB/Simulink", PROCEDIA ENGINEERING, vol. 48, 2 November 2012 (2012-11-02), pages 629-635, XP028492179, ISSN: 1877-7058, DOI: 10.1016/J.PROENG.2012.09.563 [retrieved on 2012-11-02] * the whole document * | 1-17 | |
| A | MARCONATO A ET AL: "Improved Initialization for Nonlinear State-Space Modeling", ARXIV.ORG, CORNELL UNIVERSITY LIBRARY, 201 OLIN LIBRARY CORNELL UNIVERSITY ITHACA, NY 14853, 23 April 2018 (2018-04-23), XP081229097, DOI: 10.1109/TIM.2013.2283553 * the whole document * | 1-17 | |
| A | US 2022/122207 A1 (VAN GILS PIETER [ES] ET AL) 21 April 2022 (2022-04-21) * the whole document * | 1,13-17 | **TECHNICAL FIELDS SEARCHED (IPC)** |

The present search report has been drawn up for all claims

| Place of search | Date of completion of the search | Examiner |
|---|---|---|
| The Hague | 4 October 2023 | Abbing, Ralf |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 16 9445

This annex lists the patent family members relating to the patent documents cited in the above-mentioned European search report.
The members are as contained in the European Patent Office EDP file on
The European Patent Office is in no way liable for these particulars which are merely given for the purpose of information.

04-10-2023

| Patent document cited in search report | | Publication date | Patent family member(s) | | Publication date |
|---|---|---|---|---|---|
| US 2014372091 | A1 | 18-12-2014 | CA | 2913322 A1 | 18-12-2014 |
| | | | CN | 105814499 A | 27-07-2016 |
| | | | EP | 3008528 A1 | 20-04-2016 |
| | | | JP | 2016521895 A | 25-07-2016 |
| | | | JP | 2020017293 A | 30-01-2020 |
| | | | KR | 20160021209 A | 24-02-2016 |
| | | | US | 2014372091 A1 | 18-12-2014 |
| | | | US | 2020012754 A1 | 09-01-2020 |
| | | | WO | 2014201455 A1 | 18-12-2014 |
| US 2022122207 | A1 | 21-04-2022 | CN | 114385980 A | 22-04-2022 |
| | | | EP | 3989014 A1 | 27-04-2022 |
| | | | US | 2022122207 A1 | 21-04-2022 |

EPO FORM P0459

For more details about this annex : see Official Journal of the European Patent Office, No. 12/82